(19) Europäisches Patentamt / European Patent Office / Office européen des brevets

(11) **EP 4 608 115 A1**

(12) **EUROPÄISCHE PATENTANMELDUNG**

(43) Veröffentlichungstag:
27.08.2025 Patentblatt 2025/35

(21) Anmeldenummer: 25000018.9

(22) Anmeldetag: 22.02.2025

(51) Internationale Patentklassifikation (IPC):
*H10N 60/00* *(2023.01)*

(52) Gemeinsame Patentklassifikation (CPC):
**H10N 60/99**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **23.02.2024 DE 102024000594**

(71) Anmelder: **Neumann, Ulrich**
**86609 Donauwörth (DE)**

(72) Erfinder: **Neumann, Ulrich**
**86609 Donauwörth (DE)**

(74) Vertreter: **Mederle-Hoffmeister, Stefan**
**Postfach 10 21 43**
**86011 Augsburg (DE)**

(54) **ANORDNUNG VON ANEINANDER GRENZENDEN ABSCHNITTEN VERSCHIEDENARTIGER LEITUNGS-MEDIEN**

(57) Anordnung von aneinander grenzenden Abschnitten verschiedenartiger Leitungs-Medien, wobei in einem ersten Abschnitt (18) ein supraleitendes Medium vorliegt, in dem photonenartige Cooper-Paare entstehen und in mindestens einem zweiten Abschnitt (19) ein verschiedenartiges Leitungs-Medium vorliegt in dem die photonenartigen Cooper-Paare weitergeleitet werden.

Figur 7

**Beschreibung**

TECHNISCHES GEBIET

Die vorliegende Erfindung bezieht sich generell auf die Entstehung und Weiterleitung von Cooper-Paaren der Supraleitung.

Supraleiter müssen mit erheblichem Aufwand permanent gekühlt werden. Zudem kann Supraleitung mit der Standardphysik nicht ausreichend erklärt werden. Die neuen deterministischen Modelle aus [2] bieten eine Erklärung. Die Fermionen, der Doppel-Magnetfluss-Ring (DMFR) eines Fermions, der deterministische Bau der Atome, die Bosonen bzw. Photonenartigen, das Photon und das ähnliche photonenartige Cooper-Paar sind dabei wichtige Komponenten, um "Supraleitung" zu verstehen.

Das entscheidende Mittel zur Nutzung der Erfindung ist die Trennung von Entstehung der Cooper-Paare bei Temperaturen im kryogenen Bereich und deren Weiterleitung. Die Entstehung unterliegt zwei Bedingungen, die nur etwa ein Drittel aller Elemente des Periodensystems erfüllt. Diese Bedingungen werden nicht nur von intrinsischen Eigenschaften der Atome der betreffenden Elemente erfüllt, dies kann auch durch Wechselwirkung dieser Atome mit benachbarten anderen Atomen erfolgen. Damit können auch solche Atome Cooper-Paare abgeben, die im Periodensystem nicht als supraleitend ausgewiesen sind. Die Sprungtemperatur ist eine Folge der Intensität der Wechselwirkung zwischen benachbarten Atomen und von deren innerer Struktur. Zur inneren Struktur der Atome gehören "Störstellen", die in der Standardphysik nicht bekannt sind.

Die Weiterleitung einmal gebildeter Cooper-Paare kann in einer Vielzahl verschiedener Medien erfolgen, wie das auch vom Photon bekannt ist z. B. transparente Flüssigkeiten, Kunststoffe, Gläser, Halbleiter, Gase oder ein Vakuum. Kühlung auf extrem tiefe Temperaturen ist für einmal gebildete CPe nicht notwendig.

In dieser Schrift wird das Cooper-Paar gemäß der Standardlehre bzw. der BCS-Theorien vom Cooper-Paar der neuen Modelle unterschieden. Daher werden folgende Kürzel verwendet: $CP_{BCS}$ und $CP_{nM}$. Außerdem werden diese beiden Kürzel dekliniert, so dass sie in sprachlich korrekter Weise in verschiedenen Satzformationen gebraucht werden können. So kommen für Genitiv $CPs_{BCS}$ und $CPs_{nM}$, für Plural $CPe_{BCS}$ und $CPe_{nM}$ und für Dativ Plural $CPen_{BCS}$ und $CPen_{nM}$ vor.

STAND DER TECHNIK

In den zurückliegenden Jahrzehnten hat die Technik auf dem Gebiet der Supraleitung große Fortschritte gemacht. Dies beruht sehr stark auf der Entdeckung der Hochtemperatur-Supraleiter (HTSL), die im Gegensatz zu allen früher entdeckten Supraleitern bei Kühlung durch flüssigen Stickstoff (77 K) noch supraleitend sind.

In der Standardlehre der Physik wird die Supraleitung am häufigsten mit der BCS-Theorie erklärt. Von dieser Theorie gibt es sehr viele Varianten, die meist dann entwickelt wurden, wenn im Laufe der letzten etwa 110 Jahre weitere supraleitende Materialien entdeckt wurden.

Im periodischen System der Elemente werden etwa 40 Elemente ausgewiesen, die supraleitend sind, siehe z. B. [1], S. 25, Abb. 11. Keines dieser Elemente hat eine Sprungtemperatur von über 10 K. Die Anzahl der supraleitenden Materialien vervielfacht sich, wenn aus diesen Elementen Verbindungen oder Legierungen aus zwei oder mehr Elementen hergestellt werden. Die allermeisten dieser Materialien haben metallischen Charakter, so dass die BCS-Theorie oder eine ihrer Varianten angewandt werden konnte.

Das Kernelement der BCS-Theorie ist das "Cooper-Paar" - $CP_{BCS}$. Danach besteht ein $CP_{BCS}$ aus zwei Elektronen mit entgegengesetztem Spin, die ein neues Teilchen, und zwar ein Boson, bilden.

Die Interpretation bzw. das Verständnis der Supraleitung wurde mit der Entdeckung zweier weiterer Materialklassen sehr schwierig. Im Jahr 2001 entdeckte der Japaner J. Akimitsu die Supraleitfähigkeit von Magnesiumdiborid $MgB_2$ mit einer Sprungtemperatur von $T_c = 39$ K. Keines der beiden beteiligten Elemente Magnesium und Bor ist supraleitend. Im Jahr 1986 publizierten J. G. Bednorz und K. A. Müller die Entdeckung der Supraleitfähigkeit von Hochtemperatur-Supraleitern (HTSL), die aus keramischen Schichtkristallen mit einem vergleichsweise komplizierten Aufbau bestehen, später als Cuprate bezeichnet. Schließlich wurden HTSL entwickelt, die entweder enorme Stromdichten von Mega-Ampere pro Quadratzentimeter ($MA/cm^2$) aufweisen und/oder Sprungtemperaturen von über 100 K haben.

Aus den bisherigen Theorien zur Supraleitung kann man nicht ableiten, wie Materialien zu finden sind, die noch höhere Sprungtemperaturen $T_c$ haben. Wünschenswert wären aus technologischer Sicht Materialien, die bei Raumtemperatur supraleitend sind. Mit solchen Materialien könnten viele technische Vorteile erreicht werden.

KURZDARSTELLUNG DER ERFINDUNG

Technische Probleme

In den Absätzen [0006] und [0007] wird beschrieben, dass die BCS-Theorie zum generellen Verständnis der Supraleitungsvorgänge nicht ausreicht. Es wird ein tieferes Verständnis benötigt. Die Definition des Begriffes Cooper-Paar gemäß der BCS-Standardtheorie wird in Absatz [0005] gegeben. Danach ist dieses Teilchen zwar ein Boson aber die Grundvorstellung, dass der elektrische Strom von Elektronen getragen wird, bleibt erhalten. Diese Vorstellung und damit die BCS-Theorie können nach den neuen Modellen nicht länger aufrecht erhalten werden.

Bei vielen alltäglichen Anwendungen der Übertragung elektrischen Wechsel- oder Gleichstroms sind Verluste tragbar, weil sie in der Größenordnung von sehr wenigen Prozent der übertragenen Energie liegen. Das gilt für alle Niedervolt-Leitungen, -Motoren, - Transformatoren und -Haushaltsgeräte sowie Schaltungen von technischen Anlagen oder für Computer usw. Mit Hochspannungs-Leitungen, -Transformatoren u. a. Einrichtungen werden jedoch sehr große Energiemengen umgesetzt, so dass es sich lohnt, auch wenige Prozent dieser großen Energiemengen einzusparen. Aus diesem Grund wurden weltweit viele Patente angemeldet, die zum Ziel hatten, die Leitungsverluste mit Hilfe von Leitungen aus supraleitendem Material zu vermindern oder zu vermeiden. Die Verluste solcher modifizierten und gekühlten Leitungen können zwar vermindert werden, aber der Aufwand für die komplizierteren Ausführungen der Leitungen und der zugehörigen Kühleinrichtungen ist doch beträchtlich.

Vor der Entdeckung der HTSL wäre der technische und wirtschaftliche Aufwand für die Kühlung von Hochspannungsleitungen bis nahe an den absoluten Nullpunkt zu groß gewesen. Mit den HTSLn scheint dieser Aufwand tragbar zu werden. Zwei Argumente befördern diese Bemühungen: 1. Wie eingangs erwähnt, bleiben HTSL auch bei Kühlung mit flüssigem Stickstoff supraleitend. 2. Es gibt HTSL-Varianten, die sehr hohe Stromdichten in der Größenordnung von $MA/cm^2$ ertragen. Aber Kühlung ist weiterhin notwendig.

In Patenten werden nun Leitungen beschrieben, die das eine oder das andere oder beide o. g. Merkmale mit Hilfe zusätzlichen Aufwands erfüllen. Darüber hinaus wird beschrieben, dass Kühlaggregate z. B. im Abstand von mehr als 20 km an die Leitungen angeschlossen werden müssen, EP 3281211 B1.

Alle beschriebenen Supraleitungs-Einrichtungen (Leitungen, Magnete, Transformatoren) benötigen mindestens die Kühlung mit flüssigem Stickstoff und den zugehörigen apparativen Aufwand. Dies gilt es zu vermeiden. Demnach ist es Aufgabe der vorliegenden Erfindung, eine Supraleitungs-Einrichtung mit verringertem Kühlbedarf bzw. Kühlaufwand anzugeben.

Lösung der Probleme

Das Verständnis für Supraleitung bzw. die Lösung der Probleme kann nur auf der Basis neuer Vorstellungen erreicht werden. Diese Vorstellungen sind in der umfangreichen Publikation [2] festgehalten, können hier jedoch nicht vollständig wiederholt werden. Entscheidend ist, dass Photon und Cooper-Paar sehr ähnliche Strukturen aufweisen, wie in [2], Kapitel 22, insbesondere Kapitel 22.1 beschrieben wird. Es ist nun unter dem Begriff Cooper-Paar ein neuer Inhalt zu verstehen, der in den nächsten Absätzen beschrieben wird.

Ein Photon setzt sich gemäß [2] aus den Strukturen von Elektronen und Positronen einer Atomhülle zusammen. Dadurch ist seine elektrische Ladung null. Analog setzt sich ein Cooper-Paar aus Strukturen zweier Elektronen einer Atomhülle zusammen. Dadurch ist seine elektrische Ladung negativ. Ein Cooper-Paar transportiert negative elektrische Ladung.

Zwei weitere wesentliche Aspekte sind zu benennen: 1. Elektronen wie Positronen gehören zu den Fermionen. Ein Photon dagegen ist ein Boson. Zu diesen beiden Klassen von Elementarteilchen gehören gemäß [2] grundsätzlich verschiedene Vorstellungen, die einander ausschließen. Fermionen sind (im Wesentlichen) ortsfest, Bosonen fliegen (im Wesentlichen) mit Lichtgeschwindigkeit. Ein $CP_{nM}$ der neuen Vorstellungen ist wie das Photon ein Boson, also ein Photonenartiges, und deswegen (im Wesentlichen) mit Lichtgeschwindigkeit unterwegs. 2. Daher ist ein $CP_{nM}$ der neuen Vorstellungen masselos (im Gegensatz zu den Vorstellungen der BCS-Theorie).

Als Photonenartiges entsteht ein Photon in einer Atomhülle, verlässt diese und kann dann durch sehr verschiedenartige Medien fliegen. Zu diesen Medien gehören das Vakuum, Gase, Luft, Flüssigkeiten wie Wasser oder Öle, Kristalle von Gestein (Dünnschicht-Mikroskopie), Gläser, Kunststoffe aber auch Metalle oder Halbleiter in dünnen Schichten.

Als Photonenartiges entsteht ein $CP_{nM}$ analog in einer Atomhülle, verlässt diese und kann dann durch verschiedenartige Medien fliegen. Für die Entstehung eines $CPs_{nM}$ sind jedoch zwei Bedingungen zu erfüllen, die beim Photon wie selbstverständlich in jedem Atom von jedem Element des Periodensystems vorliegen. Beim $CP_{nM}$ werden diese zwei Bedingungen nur bei bestimmten Elementen des periodischen Systems erfüllt, s. Absatz [0004].

Mit dem Absatz [0017] erfolgt die entscheidende Aussage zur Lösung des technischen Problems, das darin besteht, dass alle beschriebenen Supraleitungs-Einrichtungen bzw. -Materialien Kühlung mit flüssigem Stickstoff (oder gar flüssigem Helium) und den zugehörigen apparativen Aufwand benötigen.

Ein $CP_{nM}$ der neuen Vorstellungen kann durch verschiedenartige Medien fliegen. Damit entfällt die aus allen bisherigen technischen Systemen abgeleitete Notwenigkeit und die aus allen bisherigen Theorien zur Supraleitung (wie die der BCS-Lehre) abgeleitete Forderung, wonach sich ein $CP_{nM}$ nur in supraleitenden, d. h. gekühlten, Medien bewegen kann. Die empirische Suche nach Materialien mit noch höheren Sprungtemperaturen $T_c$ als bei den HTSLn, s. Absatz [0007], ist irrelevant.

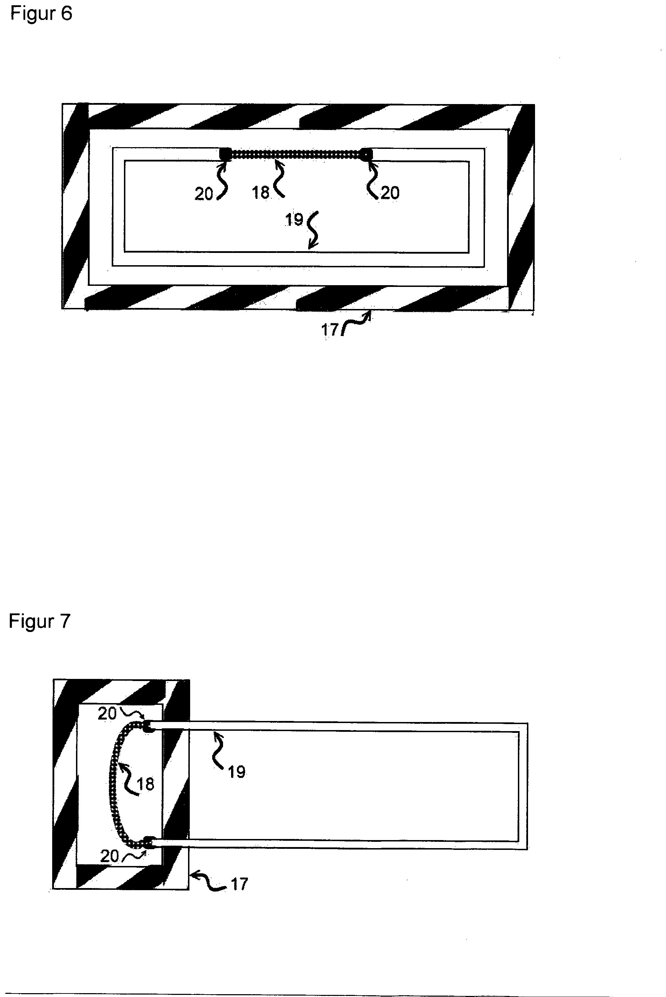

Die Lösung des Problems ist, dass ein $CP_{nM}$ nicht nur durch die empirisch gefundenen supraleitenden Metalle oder HTSL sondern auch durch Gläser, Kunststoffe, Halbleiter, Gase, ein Vakuum u. a. Medien fliegen kann, siehe auch Figur 7. Die Transparenz dieser Medien für $CPe_{nM}$ ist noch im Detail zu erforschen.

Diese Medien müssen nicht gekühlt werden!

Demnach wir die der vorliegenden Erfindung zugrundeliegende Aufgabe durch eine Anordnung von aneinander grenzenden Abschnitten verschiedenartiger Leitungs-Medien gemäß Patentanspruch 1 gelöst. Fortbildungen der erfindungsgemäßen Anordnung sind in den abhängigen Patentansprüchen angegeben.

Die der Erfindung zugrundeliegende Aufgabe wird demnach von einer Anordnung von aneinander grenzenden Abschnitten verschiedenartiger Leitungs-Medien gelöst, wobei in einem ersten Abschnitt ein supraleitendes Medium vorliegt in dem photonenartige Cooper-Paare entstehen und wobei in mindestens einem zweiten Abschnitt ein verschiedenartiges Leitungs-Medium vorliegt in dem die photonenartigen Cooper-Paare weitergeleitet werden.

Das supraleitende Medium bzw. der Supraleiter kann ein solches Element oder mehrere solche Elemente des Periodensystems der Elemente enthalten, von deren Atomen CPenM bei Temperaturen im kryogenen Bereich freigesetzt werden können und dann weitergeleitet werden.

Das eine oder die mehreren Elemente kann/können im Periodensystems der Elemente als nicht supraleitend ausgewiesen sein bzw. nicht als supraleitend ausgewiesen sein. In anderen Worten gesagt kann/können das eine Element oder die mehreren Elemente nichtsupraleitende Elemente bzw. bei allen Bedingungen normalleitende Elemente sein..

Optional ist das supraleitende Medium bzw. der Supraleiter ein Hoch-Temperatur-Supraleiter.

Das supraleitende Medium bzw. der Supraleiter kann ein Supraleiter sein, der eine Stromdichte von mindestens einem Mega-Ampere pro Quadratzentimeter ermöglicht bzw. zum Durchleiten einer Stromdichte von mindestens einem Mega-Ampere pro Quadratzentimeter ausgebildet bzw. geeignet ist.

Das Leitungs-Medium oder die Leitungs-Medien für die photonenartigen Cooper-Paare kann/können aus der Gruppe der für CPenM transparenten polaren oder unpolaren Flüssigkeiten wie z. B. Wasser, Alkohole oder Öle und/oder aus der Gruppe der für CPenM transparenten Kunststoffe und/oder aus der Gruppe der für CPenM transparenten Gläser und/oder aus der Gruppe der für CPenM transparenten Halbleiter sein.

Die Gläser liegen in möglichen Ausführungsformen in der Form von Glasfasern vor.

Die Glasfasern liegen optional in der Qualität hochtransparenter Lichtleitfasern vor.

Die Kunststoffe können in der Form von Kunststofffasern vorliegen.

Die sehr hohe Stromdichten von $MA/cm^2$ leitenden Glas- oder Kunststoffasern können als Wicklungen für Magnete, Transformatoren, Motoren oder Generatoren eingesetzt werden. In anderen Worten gesagt können die Glas- oder Kunststoffasern Bestandteil von Magneten, Transformatoren, Motoren oder Generatoren sein.

Die für photonenartige Cooper-Paare (CPenM) transparenten Halbleiter können zu einem Mikrochip gehören.

Elektrische Ladung kann durch photonenartige Cooper-Paare (CPenM) in einem Halbleiter-Mikrochip transportiert werden.

Die Frequenz bzw. Wellenlänge der CPenM kann an die Transparenz der Halbleiter-Werkstoffe der IC 25 angepasst sein.


LISTE DER ZEICHNUNGEN

Figur 1a
Schnitt durch den schematischen Doppel-Magnetfluss-Ring (dicke durchgezogene Linien) mit umgebenden elektrischen Flusslinien (dünne unterbrochene Linien) eines Fermions. Die Zuordnung von magnetischem Fluss und elektrischem Fluss erfolgt nach der Rechte-Hand-Regel (linksdrehend).


Figur 1b
Schnitt durch den schematischen Doppel-Magnetfluss-Ring (dicke durchgezogene Linien) mit umgebenden elektrischen Flusslinien (dünne unterbrochene Linien) eines Fermions. Die Zuordnung von magnetischem Fluss und elektrischem Fluss erfolgt nach der Linke-Hand-Regel (rechtsdrehend).


Figur 2a

Schematische Draufsicht (ohne perspektivische Verzerrung) auf ein Sauerstoffatom $^{16}_{8}O$

Figur 2b

Schematischer Schnitt durch die Atomhülle eines Sauerstoffatoms $^{16}_{8}O$

Figur 3

Die schematische Darstellung zeigt links je einen DMFR einer Elektronen- und einer Positronen-Struktur, deren Achsen im rechten Winkel zueinander stehen. Im rechten Teil wird die schematische Struktur eines ankommenden oder eben gestarteten Photons gezeigt.

Figur 4a

Schematische Draufsicht (ohne perspektivische Verzerrung) auf ein Kohlenstoffatom $^{12}_{6}C$

Figur 4b

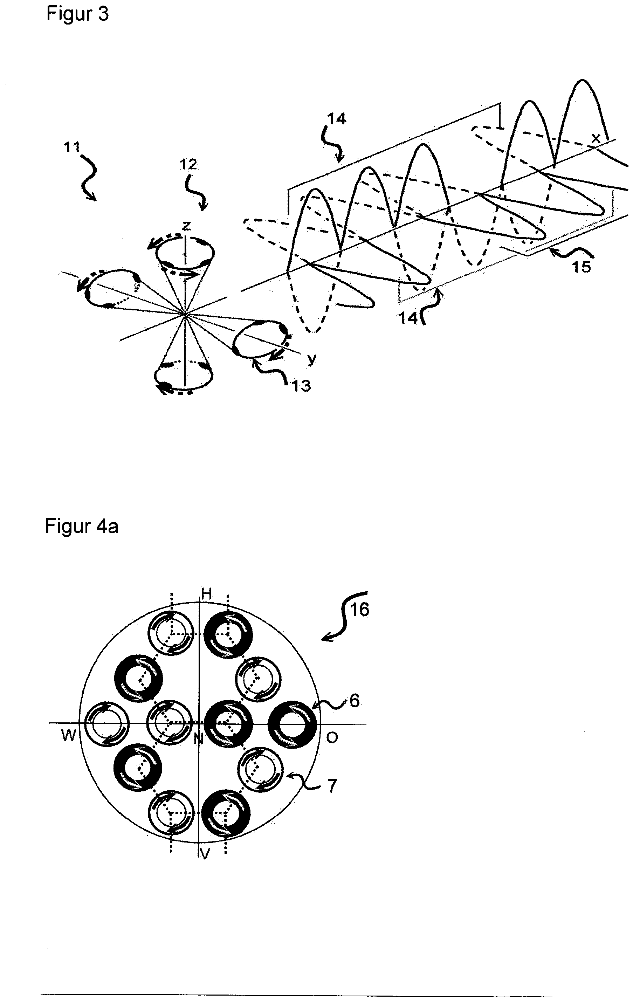

Schematische Draufsicht (ohne perspektivische Verzerrung) auf ein Kohlenstoffatom $^{12}_{6}C$, gegenüber Figur 4a um 90° versetzte Perspektive

Figur 5

Supraleitender Ring bestehend aus einem Supraleiter mit eingesetztem kurzem Glaskörper in einem Kryostaten.

Figur 6

Supraleitender Ring bestehend aus einem kurzen Supraleiter und langen Glasfasern in einem Kryostaten.

Figur 7

Supraleitender Ring, der zum Teil in einem Kryostaten und zum Teil außerhalb verläuft. Der kalte Teil des Ringes besteht mindestens teilweise aus einem supraleitenden Werkstoff, während außerhalb des Kryostaten andere transparente Medien wie Gläser, Kunststoffe, Halbleiter, Gase, ein Vakuum oder andere Medien die $CPe_{nM}$ leiten.

Figur 8

Supraleitender Ring, der zum Teil in einem Kryostaten und zum Teil außerhalb verläuft. In den nicht gekühlten Teil sind übliche Komponenten eines Stromkreises eingebaut wie z. B. eine Magnetspule, ein integrierter Chip oder auch eine Verzweigung.

Figur 9

Dargestellt sind zwei supraleitende Ringe, die jeweils zum Teil in einem Kryostaten und zum Teil außerhalb verlaufen. In den nicht gekühlten Teil eines Ringes ist jeweils eine Verzweigung eingefügt. Mit Hilfe eines an einer Verzweigung positionierten Kondensators kann ein Teil der in den Ringen umlaufenden $CPe_{nM}$ in eine "Fernleitung" zwischen den Ringen gelenkt werden.

Figur 10

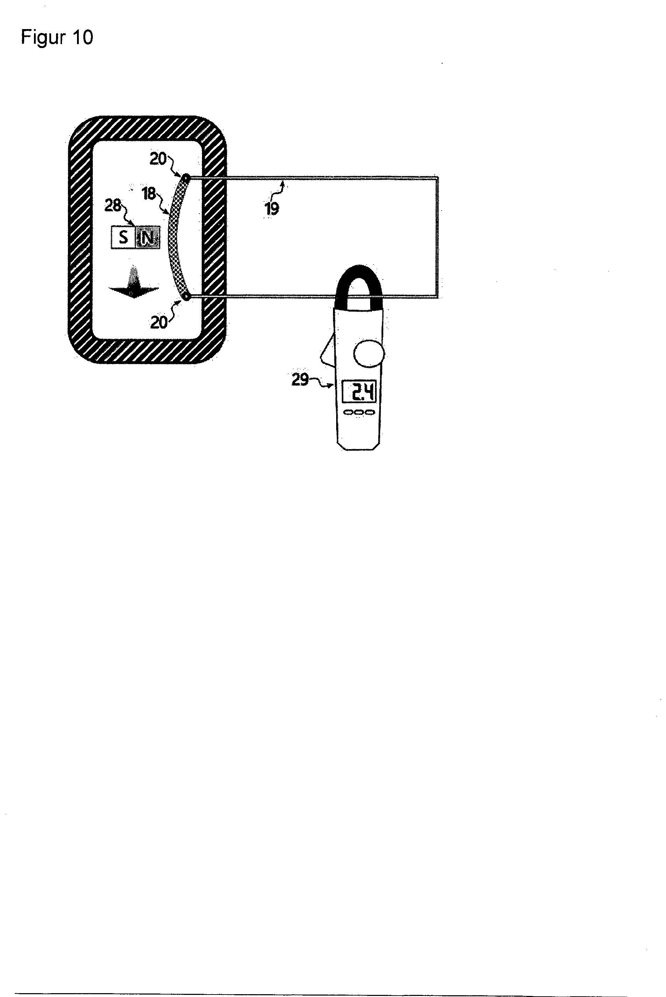

Die Figur 10 baut auf der Figur 7 auf. In Figur 10 ist zusätzlich ein bewegter Magnet im Kryostaten zu sehen. Das Magnetfeld kann über den supraleitenden Werkstoff streichen und damit photonenartige Cooper-Paare auslösen. Außerdem zeigt Figur 10 zusätzlich einen Zangenstrommesser. Dessen Zange umfasst außerhalb des Kryostaten das transparente Leitungs-Medium, das aus Gläsern, Kunststoffen, Halbleitern, Gasen, Vakuum oder anderen Medien bestehen kann.

Bezugszeichenliste

1 Schnittdarstellung eines linksdrehenden Fermions
2 magnetischer Fluss
3 elektrischer Fluss
4 Schnittdarstellung eines rechtsdrehenden Fermions
5 Draufsicht auf ein Sauerstoff-Atom

6     linksdrehender MFR

7     rechtsdrehender MFR

8     Schnitt durch ein Sauerstoff-Atom

9     nördlicher MFR eines DMFRes

10    südlicher MFR eines DMFRes

11    Doppel-Doppel-Magnetfluss-Ring

12    Vereinfachte Elektronen-Struktur

13    Vereinfachte Positronen-Struktur

14    Paket von Primärwellen des Elektrons

15    Paket von Primärwellen des Positrons

16    Draufsicht auf ein Kohlenstoff-Atom

17    Kryostat

18    Supraleiter, z. B. HTSL

19    für $CPe_{nM}$ transparenter Körper, z. B. Glas, Glasfasern, Kunststofffasern

20    Passung Supraleiter - transparenter Körper

21    Transformator

22    22*, 22** Kondensator

23    23*, 23** Verzweigung

24    Wicklung

25    Integrierter Chip (IC)

26    ein Weg für $CPe_{nM}$

27    anderer Weg für $CPe_{nM}$

28    mechanisch bewegter Magnet

29    Zangenstrommesser

DETAILLIERTE BESCHREIBUNG

Die physikalischen Grundlagen

In den vorhergehenden Absätzen wird beschrieben, welcher Inhalt unter einem photonenartigen $CP_{nM}$ der neuen Modelle zu verstehen ist. Daher werden im Folgenden bis auf wenige Ausnahmen nur die Kürzel $CP_{nM}$ bzw. $CPe_{nM}$ verwendet.

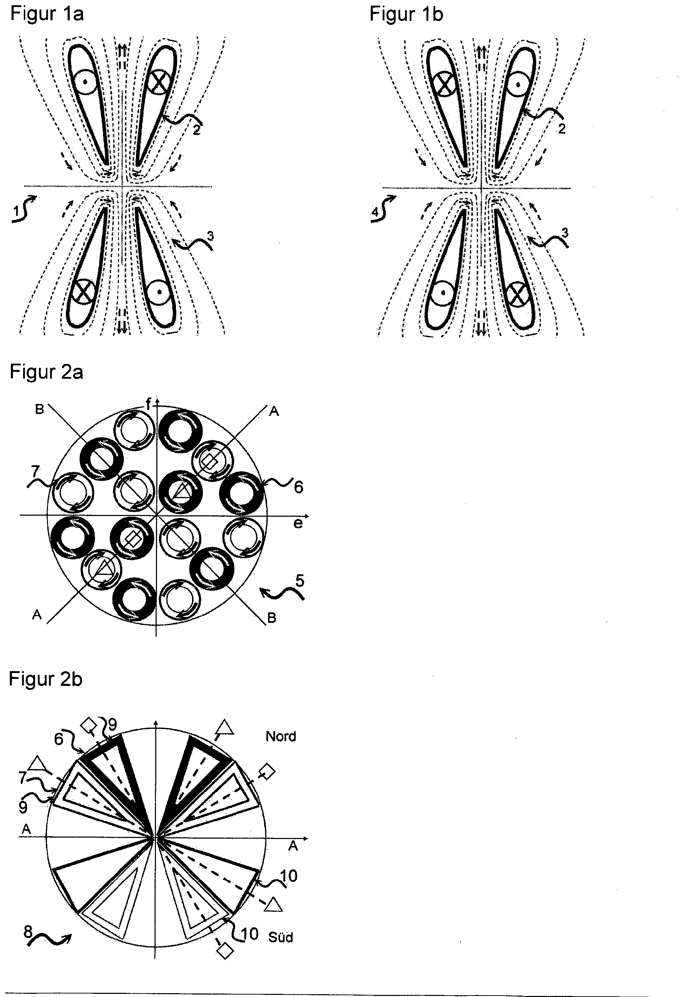

Zu der hier beschriebenen Erfindung gehören physikalische Grundlagen, die in der Standardphysik nicht bekannt sind. Es genügt für das Verständnis nicht, auf die Literaturquelle [2] und die darin enthaltenen neuen Modelle mit den wichtigsten relevanten Aspekten zu verweisen. Vielmehr sollen hier Bau und Funktion elementarer Größen wie Fermionen und Bosonen beschrieben werden. Zum einen wird die Struktur der Fermionen aus magnetischen und elektrischen Feldern dargestellt, Figur 1. Zum anderen werden als Beispiele für Bosonen zwei Photonenartige beschrieben, das Photon in Figur 3 und das analog aufgebaute photonenartige $CP_{nM}$.

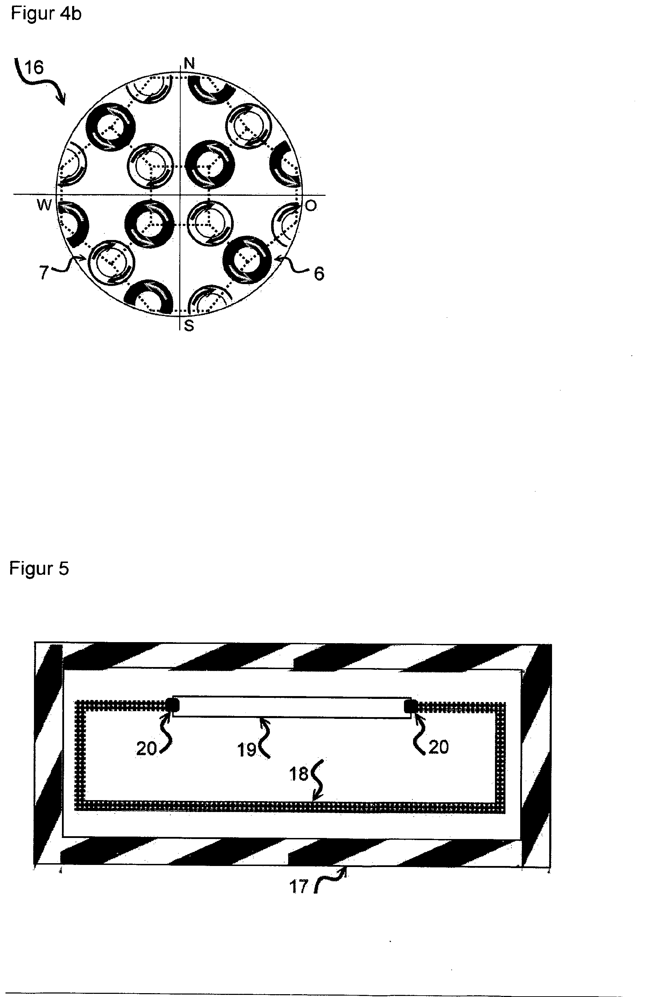

Erst mit diesen Grundlagen ergibt sich ein neues Bild des Atombaus. Hier kommt es insbesondere auf den Bau der Atomhülle an, der anhand der Beispiele aus den Figuren 2 und 4 deutlich wird. Aus diesem Bau der Atomhülle werden die Bedingungen für die Entstehung von photonenartigen Cooper-Paaren bei Temperaturen im kryogenen Bereich abgeleitet.

Es wird erklärt, warum $CPe_{nM}$ nur bei niedrigsten Temperaturen entstehen. Sogenannte "Störstellen" in einer Atomhülle und die Wechselwirkung zwischen zwei benachbarten Atomen sind Gründe, warum es HTSL geben kann. Diese Einsichten sind neu und werden hier erstmals beschrieben. Aus den Einsichten folgen die Offenbarung der Erfindung in dieser Beschreibung und die Patentansprüche.

In [2] wird die Atomhülle in deterministischer Weise beschrieben. Diese Beschreibung steht in scharfem Gegensatz zu den Wahrscheinlichkeitsvorstellungen der Standardlehre der Physik. Alle Fermionen sind gemäß [2] Doppel-Magnetfluss-Ringe (DMFRe), Figur 1. Gezeigt wird mit Figur 1a ein schematischer Schnitt eines Fermions **1** entlang der vertikalen Achse durch den Doppel-Magnetfluss-Ring **2** (dicke durchgezogene Linien) mit umgebenden elektrischen Flusslinien **3** (dünne unterbrochene Linien). Der "obere" sowie der "untere" Magnetfluss-Ring (MFR) werden jeweils nach der Rechte-Hand-Regel durchströmt (linksdrehend). Das hat mehrere Folgen: 1. Von außen gesehen werden die beiden Ringe immer gegenläufig durchströmt. Wäre das nicht so und würden die beiden Ringe von außen gesehen in derselben Richtung durchströmt, dann wären die Attraktionskräfte zwischen beiden Ringen so groß, dass die Ringe ineinander stürzten. 2. Der elektrische Fluss ist an der vertikalen Achse auf beiden Seiten vom Zentrum zum "Pol" hin gerichtet. Also liegt insgesamt kein Dipol vor. 3. Der elektrische Fluss ist in der horizontalen Ebene immer von außen zum Zentrum hin gerichtet.

Figur 1b unterscheidet sich von der Figur 1a nur dadurch, dass die MFRe jeweils nach der Linke-Hand-Regel (rechtsdrehend) durchströmt werden. Zu sehen ist ein schematischer Schnitt eines Fermions **4** entlang der vertikalen Achse durch den Doppel-Magnetfluss-Ring **2** (dicke durchgezogene Linien) mit umgebenden elektrischen Flusslinien **3** (dünne unterbrochene Linien).

Eine Atomhülle setzt sich aus den DMFRen der beteiligten Elektronen zusammen. Dabei entspricht die Zahl der DMFRe der Elektronen der Zahl der Protonen im Atomkern. Den Elektronen-Strukturen sind in der Atomhülle Positronen-Strukturen aus DMFRen zugeordnet. Deren Anzahl entspricht der Zahl der Neutronen im Kern. Weil sich diese Vorstellungen erheblich von denen der Standardphysik unterscheiden, wird empfohlen, die Abbildungen für sehr einfache Atommodelle in [2] anzusehen. In Kapitel 15.1, Seite 264 werden die Atommodelle von Tritium und Helium unter verschiedenen Perspektiven gezeigt. Tritium hat drei DMFRe und Helium vier.

Mit diesen Abbildungen wird insbesondere die Verteilung der links- und rechtsdrehenden MFRe deutlich. Bei Helium tritt im periodischen System erstmalig das sogenannte "Standardelement" der DMFRe auf. Dabei sind z. B. um einen zentralen linksdrehenden MFR gleichmäßig drei rechtsdrehende MFRe angeordnet bzw. umgekehrt: Um einen zentralen rechtsdrehenden MFR stehen drei linksdrehende MFRe. Dieses "Standardelement" tritt bei sehr vielen Elementen im periodischen System wieder auf, z. B. beim Sauerstoff-Atom $^{16}_{8}O$, s. Figuren 2a und 2b. In jedem Quadranten der "Nord-" und der "Südhalbkugel" ist ein Standardelement angeordnet. Das Standardelement ist eine besonders stabile Konstellation, die durch eine sehr feste gegenseitige Attraktion der jeweils vier beteiligten DMFRe hervorgerufen wird.

Wir sind mit Photonen sehr vertraut. Es gibt aber in der Standardphysik keine Beschreibung, wie Photonen in den Atomhüllen entstehen. Eine solche Beschreibung ist deshalb in der Standardphysik nicht möglich, weil der oben eingeführte DMFR für Fermionen nicht bekannt ist.

Photonen entstehen aus den DMFRen von Elektronen- und Positronen-Strukturen, weshalb ein Photon die elektrische Ladung null hat. In der Figur 3 wird links schematisch je ein DMFR einer Elektronen-Struktur **12** und einer Positronen-Struktur **13** gezeigt, deren Achsen im rechten Winkel zueinander stehen. Diese Einheit wird auch als Doppe-Doppel-Magnetfluss-Ring (DDMFR) **11** bezeichnet. In den Figuren 1a und 1b wird gezeigt, dass die MFRe von elektrischen Feldern umfasst werden. In den folgenden schematischen Darstellungen werden die elektrischen Felder zwecks Vereinfachung nicht mehr gezeigt, sondern nur noch die Magnetflussringe, z. B. in Form abstrahierter "Trichter".

In Absatz [0022] werden links- und rechtsdrehende DMFRe unterschieden. In Figur 3 ist nun zu sehen, dass ein linksdrehender DMFR einer (nun abstrahierten) Elektronen-Struktur **12** zugeordnet wird und ein rechtsdrehender DMFR zu einer (nun abstrahierten) Positronen-Struktur **13** gehört. Diese Zuordnung von "linksdrehend und Elektron" sowie "rechtsdrehend und Positron" beruht nicht auf einer physikalischen Einsicht und ist insofern willkürlich. Die Zuordnung wird in [2] durchgehend beibehalten. Das gilt auch für diese Schrift.

Im rechten Teil der Figur 3 wird schematisch die Struktur eines in der Atomhülle ankommenden oder eben von dort gestarteten Photons gezeigt. Die dort gezeigten Sinuswellen werden als Primärwellen bezeichnet. Diese linearen Primärwellen der Photonen werden beim Landen auf die MFRe der Fermionen (Elektronen bzw. Positronen) aufgewickelt und beim Starten von dort abgewickelt. Die Primärwellen schwingen in zwei Ebenen, die ebenfalls im rechten Winkel zueinander stehen. Man sieht ein Paket von Primärwellen des Elektrons **14** und ein Paket von Primärwellen des Positrons **15.** In [2] wird beschrieben, dass die Primärwellen in den beiden Ebenen Wellenlängen bzw. Frequenzen aufweisen, die sehr wenig verschieden sind. Im Ergebnis führen die Primärwellen der beiden Ebenen während des Anfluges auf ein Atom oder nach dem Start von einem Atom - auch generell beim Flug des Photons - eine Schwebung aus. Die Wellenlänge dieser Schwebung ist deutlich (um Faktoren von $10^2$ bis $10^4$) größer als die Wellenlängen der Primärwellen. Wir beobachten die Schwebungen der Primärwellen z. B. als sichtbares Licht. Die hier beschriebene Sichtweise auf das Photon ist in der Standardlehre der Physik nicht bekannt.

Die notwendigen Bedingungen für die Entstehung von Photonen sind nun genannt:

- In der jeweiligen Atomhülle müssen eine Elektronen-Struktur und eine Positronen-Struktur im rechten Winkel zueinander vorkommen.
- In diesem Falle ist damit zugleich gesagt, dass beide Strukturen von (minimal) verschiedener Energie sein müssen bzw. (minimal) verschiedene Primärwellenlängen haben müssen. Nur so kann das entstehende Photon eine Schwebung aufweisen.

Beide Bedingungen für das Entstehen von Photonen sind wie selbstverständlich in allen Atomen aller Elemente des Periodensystems erfüllt.

$CPe_{nM}$ tragen negative elektrische Ladungen. Ein $CP_{nM}$ entsteht aus dem DMFR einer Elektronen- und dem DMFR einer zweiten Elektronen-Struktur. Analog zum Photon lauten die notwendigen Bedingungen für die Entstehung eines CPs:

- In der jeweiligen Atomhülle müssen zwei Elektronen-Strukturen im rechten Winkel zueinander vorkommen.

- Die beiden Strukturen müssen von minimal verschiedener Energie sein. Nur so kann das entstehende Photonenartige bzw. das $CP_{nM}$ eine Schwebung aufweisen.

Diese zwei Bedingungen für das Entstehen von $CPen_{nM}$ werden nur bei bestimmten Elementen des Periodensystems erfüllt.

Als Negativbeispiel wird in Figur 2a eine schematische Draufsicht **5** (ohne perspektivische Verzerrung) auf ein Sauerstoffatom gezeigt und mit Figur 2b ein schematischer Schnitt **8** durch die Atomhülle eines Sauerstoffatoms dargestellt. Ein Sauerstoffatom hat 8 Protonen und damit auch 8 Elektronen-Strukturen sowie 8 Positronen-Strukturen. In der Figur 2a sind entlang der Schnittlinie AA die MFRe der Elektronen- und Positronen-Strukturen mit Dreiecken bzw. Rauten markiert, in der Figur 2b findet man die entsprechenden Strukturen anhand der Symbole wieder. Im Folgenden wird aus der Sicht der "Nordhalbkugel" argumentiert. Deshalb sind die MFRe **10** der "Südhalbkugel" in der Figur 2b blasser angelegt und die dort gezeigten MFRe weisen die gegenläufigen Drehrichtungen der nördlichen MFRe **9** auf.

Auch in der Schnittdarstellung sind die Elektronen-Strukturen **6** schwarz und linksdrehend, die Positronen-Strukturen **7** hell und rechtsdrehend angelegt. Man sieht, dass zwei mit Dreiecken markierte Achsen einen rechten Winkel bilden und dass zwei mit Rauten markierte Achsen ebenfalls einen rechten Winkel bilden. Aber diese rechten Winkel gehören jeweils zu einem Paar aus DMFRen von (schwarzen und linksdrehenden) Elektronen- **6** und (hellen und rechtsdrehenden) Positronen-Strukturen **7**. Damit sind diese beiden Paare in der Lage normale Photonen abzugeben.

Aber Paare aus zwei Elektronen-Strukturen (in Figur 2 schwarz und linksdrehend dargestellt) bilden keinen rechten Winkel. Also kann ein CP aus zwei Elektronen-Strukturen wegen der fehlenden ersten Bedingung (rechter Winkel) nicht im Sauerstoffatom entstehen. Diese Aussage gilt für die meisten Elemente der zweiten und dritten Periode des Periodensystems. Die Standardphysik, z. B. die BCS-Lehre, kann keine Ursache dafür benennen, dass z. B. Sauerstoff nicht supraleitend sein kann.

Weil die Standard-(BCS-)Lehre in den letzten Jahrzehnten nicht die Vorstellung eines photonenartigen CPs entwickelt hat, wurden alle Forschungen auf die Werkstoff-Frage konzentriert. Ein durchschlagendes Verständnis von Ursache und Wirkung der Supraleitung wurde nicht erreicht, obwohl eine große Fülle von Aspekten untersucht wurde.

Das liegt zum einen an der Vorstellung, dass elektrische Ladung nur durch Teilchen wie Elektronen transportiert werden kann. Zum anderen liegt es an den oben erwähnten Wahrscheinlichkeitsvorstellungen zur Atomhülle. Zum Dritten gibt es das Schalenmodell, nach dem die Atomhülle Elektronen in permanent unterschiedlichen Energiezuständen enthält. Alle Vorstellungen stehen in krassem Gegensatz zu dem hier vorgetragenen deterministischen Modell. Zu diesem gehört eine größere Zahl von spezifischen Begriffen, die auch zur Beschreibung der Erfindung benutzt werden. Zu den Begriffen zählen:

- Fermionen bestehen aus links- oder rechtsdrehenden DMFRen; es gibt also Strömungsrichtungen in den DMFRen.
- Alle DMFRe eines Atoms haben ein gemeinsames Zentrum (was auch für die DMFRe des Kerns gilt).
- Die beiden MFRe eines DMFRes sind von außen gesehen immer gegenläufig.
- Zwei senkrecht zueinander orientierte DMFRe mit einem gemeinsamen Zentrum bilden einen DDMFR, der Photonenartige abgeben kann.
- Photonenartige sind Schwebungen, die von den Primärwellen gebildet werden, welche die DDMFRen abgeben.
- Primärwellen haben je nach Größe des Atoms Frequenzen von etwa $10^{19}$ bis $10^{18}$ Hz. Die daraus resultierenden Schwebungen haben um die Faktoren $10^2$ bis $10^4$ geringere Frequenzen.
- Atomhüllen sind hochgradig strukturiert.
- Ein wichtiges Merkmal sind die Nahzonen benachbarter DMFRe in Atomhüllen.
- Innerhalb einer Atomhülle gibt es Gruppen von DMFRen wie z. B. das Standardelement.
- Wenn benachbarte DMFRe in der Nahzone gleichgerichtete Strömungsrichtungen haben führt das zu Attraktion zwischen beiden. Wenn entgegengesetzte Strömungsrichtungen vorliegen, wird dies als "Störstelle" oder "Störzone" bezeichnet.
- Je mehr Neutronen ein Atom aufweist, umso mehr Störstellen enthält das Atom. Störstellen bestimmen auch die Stabilität eines Atoms bzw. einer Atomhülle.
- Störstellen sind im Falle der Supraleitung auch verantwortlich für die strukturelle Ungleichheit von zwei Elektronen-Strukturen in einer Atomhülle. Bei bestimmten Elementen sind sie auch verantwortlich für die Katalysator-Eigenschaft oder für den Ferromagnetismus.

Die Supraleiter und die Entstehung der $CPe_{nM}$

Die große Mehrzahl der supraleitenden Elemente gehört zu den metallischen Übergangselementen der 4. bis 6. Periode des Periodensystems, beginnend mit Titan in der 4. Periode und endend mit Quecksilber, Tallium und Blei in der 6. Periode.

Warum werden diese Elemente erst bei tiefsten Temperaturen supraleitend?

Gemäß der Standardphysik kann nur festgestellt werden, dass es so ist. Die neuen Modelle erlauben aber eine plausible Begründung.

Die Gedankenkette beginnt beim normalen Photon wie folgt: Am absoluten Nullpunkt besteht ein Elektron nur aus einem DMFR. Knapp über 0 K werden erste Photonen eingelagert bzw. absorbiert. Die erzeugen dann eine Verstärkung des ursprünglichen Elektronen-DMFRes und eine schwache DMFR-Positronen-Struktur, so dass ein asymmetrischer Doppel-Doppel-Magnet-Fluss-Ring mit einem rechten Winkel zwischen beiden DMFRen vorliegt. Der Radius der energiearmen Positronen-Struktur ist merklich größer als der Radius des mit wenigen Photonen verstärkten DMFRes des Elektrons. Damit liegen die beiden Bedingungen für die Ausbildung einer Schwebung in einem Photon vor (rechter Winkel und verschiedene Radien), sodass das Atom Photonen emittieren kann bzw. diese vom Atom aus starten können. Hinsichtlich der Temperatur gibt es unseres Wissens keine Grenze für die Ausbildung von Photonen.

Die Gedankenkette wird analog für das photonenartige $CP_{nM}$ fortgesetzt: Die Atomhülle eines supraleitenden Übergangselementes soll zwei Elektronen mit einem rechten Winkel zwischen beiden DMFRen aufweisen (1. Bedingung). [Man kann davon ausgehen, dass diese Bedingung bei nukleonenreichen Elementen wie den Übergangsmetallen stets erfüllt wird.] Allerdings sollen die beiden Elektronen-DMFRe strukturell unterschiedlich sein. Der eine Elektronen-DMFR soll dem DMFR einer Positronen-Struktur eines benachbarten Atoms gegenüberstehen, was eine radiale Veränderung dieses DMFRes bewirkt und damit seines Radius'. Der DMFR des anderen Elektrons hat wegen der Geometrie der praktisch kugelförmigen Atomoberfläche kein Positronen-Gegenüber. Das bedeutet, die beiden DMFRe haben sehr wenig verschiedene Radien (2. Bedingung). Damit kann ein photonenartiges $CP_{nM}$ entstehen, in dem sich ebenfalls eine Schwebung bildet. Mit diesen beiden Bedingungen ist also die Voraussetzung für die Abgabe von $CPen_{nM}$ gegeben.

Damit drängt sich die Vermutung auf, dass die in Absatz [0035] bezüglich der tiefen Temperaturen gestellte Frage falsch gestellt ist. Aus der Sicht der neuen Modelle sollte man vom absoluten Nullpunkt her denken:
Warum geht die Supraleitfähigkeit der Übergangsmetalle bei geringfügiger Erwärmung bis höchstens 10 K, [1], S. 25, also bei vergleichsweise wenigen eingelagerten Photonen verloren?

Die Antwort lautet: Die DMFRe einer Atomhülle wirken durch Attraktion aufeinander ein, siehe auch Absatz [0024]. Je mehr Photonen eingelagert sind, umso intensiver sind die Flüsse der DMFRe und der sie umfassenden elektrischen Flüsse. Je intensiver die DMFRe und die elektrische Feldstärke $\mathfrak{C}$ sind, umso eher nivellieren sich die Radien gegenseitig, siehe auch [3]. Mit mehr eingelagerten Photonen bzw. Photonenartigen wird die Differenz zwischen den Radien der DMFRe der Elektronen schließlich so gering, dass die zweite Bedingung zur Ausbildung einer Schwebung nicht mehr erfüllt ist. Das Element kann bei vergleichsweise wenigen eingelagerten Photonen und kaum erhöhter Temperatur kein photonenartiges $CP_{nM}$ mehr abgeben.

Für die Erläuterung der vorliegenden Erfindung ist es zweckmäßig alle Supraleiter in drei Klassen zu unterteilen:

1. Hochtemperatur-Supraleiter
2. Binäre Verbindungen bzw. Legierungen
3. Einfache metallische Elemente

1. Hochtemperatur-Supraleiter

Für die Werkstoffe aus Yttrium-Barium-Kupfer-Oxid-Kristallen (YBCO) und Rear-Earth-Barium-Kupfer-Oxid-Kristallen (REBCO) [beides Cuprate] mit $T_c$-Werten von z. B. über 90 K bedeutet das oben Geschriebene Folgendes: Nicht das einzelne Element, wie z. B. Yttrium, bringt in diesen Werkstoffen die Fähigkeit mit, $CPe_{nM}$ abzugeben.

Vielmehr ist es die Wechselwirkung z. B. des Yttriums mit anderen Atomen des Gitters, die die Differenz der Radien von zwei Elektronen-Strukturen bzw. von deren DMFRen so groß macht, dass $T_c$-Werte von z. B. über 90 K erreicht werden.

Die am Ende des Absatzes [0034] erwähnte Atomeigenschaft der Katalysatorwirkung mit der radialen Veränderung eines DMFRes durch ein passendes benachbartes Atom ist entscheidend, siehe [2], Kapitel 16.5. Dieser Gedanke wird um die Elektronegativität ergänzt, die in [2], Kapitel 22.3 beschrieben wird. Danach zieht z. B. ein Sauerstoffatom mit sehr hoher Elektronegativität (3,50 nach Allred-Rochow) einen DMFR (von e+ oder e⁻) des Yttriums mit niedriger Elektronegativität (1,11) besonders stark an und in die Länge (vergrößert also den Radius). Dies gelingt dann besonders gut, wenn der betroffene DMFR des Yttriums auch von einer oder mehreren Störstellen umgeben ist. Es braucht dann besonders viele Photonen, um die Nivellierung aller DMFRe des Yttriums und die Nicht-Erfüllung der 2. Bedingung zu erreichen. Besonders viele eingelagerte Photonen sind gleichbedeutend mit hohen $T_c$-Werten von z. B. 90 K.

Schaut man auf das periodische System der Elemente, [1], S. 25, dann sieht man zwei Gruppen von Elementen, die unter Druck supraleitend werden. Dies sind auf der linken Seite des Systems Yttrium, Cäsium und Barium. Auf der rechten Seite sind es Silicium, Phosphor, Germanium, Arsen, Selen, Antimon, Tellur und Bismut. Die Atomradien (in pm) der Elemente sind wie folgt:

- Von der linken Seite:    Ba 215, Cs 265, Y 190.
- Von der rechten Seite:    As 119, Bi 148, Sb 139, Se 115, Te 138.

Entsprechend der Radien sind die elektrischen Feldstärken $\mathfrak{E}$ in den Atomen der linken Gruppe etwa ein Drittel niedriger als in der rechten Gruppe. Für die linke Gruppe wird ein Wert von etwa $\mathfrak{E} \approx 10^{14}$ V/m geschätzt. Demnach liegen die elektrischen Feldstärken $\mathfrak{E}$ der rechten Gruppe eher bei $\mathfrak{E} \approx 2 \cdot 10^{14}$ V/m. Die Kombination der kleineren Atomradien und der größeren $\mathfrak{E}$-Werte der rechten Gruppe führt zu kleineren Sprungtemperaturen $T_c$ als die Kombination der größeren Atomradien und der kleineren $\mathfrak{E}$-Werte der linken Gruppe.

Die höheren elektrischen Feldstärken $\mathfrak{E}$ der rechten Gruppe sind die eigentliche Ursache der höheren Elektronegativitäten der Elemente auf der rechten Seite des Periodensystems. Folglich ist die Differenz der Elektronegativitäten zwischen den "rechts" stehenden Elementen und den "ganz rechts" stehenden wie z. B. Sauerstoff oder Chlor viel kleiner. Also werden die DMFRe von Elementen der rechten Seite des Periodensystems von z. B. Sauerstoff oder Chlor nicht so stark angezogen und ihr Radius nicht so stark vergrößert. Folglich werden auch nicht so viele Photonen eingelagert werden müssen (und nicht so hohe $T_c$ erreicht werden) bis die Fähigkeit zum Aussenden von $CPen_{nM}$ verloren geht. Im Absatz [0060] wird der Unterschied zwischen der "Oxid-Familie" mit den höheren $T_c$-Werten gegenüber der "Chlor-Familie" mit den niedrigeren $T_c$-Werten beschrieben, was hier im Voraus mit der höheren Elektronegativität von Sauerstoff erklärt wird.

2. Binäre Verbindungen bzw. Legierungen

Oben wird die Wechselwirkung zweier verschiedener Elemente innerhalb einer Kristallstruktur (der Cuprate) als Ursache für hohe $T_c$-Werte beschrieben. Dieser Gedanke wird nun auf binäre Verbindungen bzw. Legierungen übertragen. Die eingangs erwähnte intermetallische Verbindung Magnesiumdiborid $MgB_2$ hat eine erstaunlich hohe Sprungtemperatur von $T_c$ = 39 K. Die liegt deutlich über der der vergleichbaren metallischen Verbindung $Nb_3Ge$, die vor der Entdeckung der Supraleitung von $MgB_2$ den bis dahin höchsten bekannten Wert von $T_c$ = 23 K hatte. Im periodischen System wird weder Magnesium noch Bor als supraleitend ausgewiesen, auch nicht unter Druck. Auch der Hinweis in WIKIPEDIA, Stichwort Magnesiumdiborid, besucht am 08.11.2023, auf die zweischichtige Struktur von $MgB_2$-Kristallen und die "graphitartige" Anordnung der Bor-Atome in ihrer Schicht lässt nicht auf Supraleitung schließen. Wie kann dann $MgB_2$ ein so guter Supraleiter sein?

In den Absätzen [0031] und [0032] wird das Sauerstoff-Atom besprochen und mit den Figuren 2a und 2b dargestellt. Sauerstoff gehört zu den Elementen mit magischen Kernzahlen. Der von Störstellen freie und dichte Aufbau des Kerns und der Hülle des Sauerstoffs $^{16}_{8}O$ ist zusammen mit dem Auftreten des Standardelementes eine Bestätigung: des empirischen Befundes der magischen Zahlen. Magnesium $^{24}_{12}Mg$ wird in der Literatur ebenfalls im Zusammenhang mit den magischen Zahlen erwähnt. In [2], Kapitel 16.3, Abbildung 16.3 wird der durch das Standardelement geprägte Aufbau des Magnesiums gezeigt, hier aber nicht wiederholt. Es genügt die Aussage, dass das Magnesium-Atom eine sehr stabile, ausgewogene und von Störstellen freie Struktur hat. Also ist die Ursache für die Supraleitung des $MgB_2$ beim Bor zu suchen.

Im periodischen System steht Kohlenstoff mit einem Proton mehr direkt neben dem Bor. In [2], Kapitel 16.6 wird die Struktur des Kohlenstoffatoms $^{12}_{6}C$ in Abbildung 16.12 gezeigt und hier als Figur 4 wiederholt. Es liegen jeweils gleich viele Protonen- und Elektronen-Strukturen sowie Neutronen und Positronen-Strukturen im Atomkern bzw. in der Atomhülle vor. Die Figur 4a zeigt eine Aufsicht auf die Struktur des Kohlenstoff-Atoms **16** von einer frei gewählten "Nordrichtung" auf den "Nordpol" N. Außer den Markierungen für Ost (O) und West (W) sind die Markierungen für vorne (V) und hinten (H) angegeben. Die Standardelemente sind nicht speziell ausgewiesen und nicht räumlich verzerrt sondern flächig dargestellt. Eine hexagonale Überstruktur ist mit den gepunkteten Linien angedeutet. Die Figur 4b zeigt eine Aufsicht auf das Kohlenstoff-Atom **16** ähnlich wie Figur 4a aber mit einem um die Ost-West-Achse um 90° nach "oben" gedrehten "Nordpol" N. Die gepunkteten Linien zeigen in dieser Ansicht zusätzlich zur hexagonalen Überstruktur eine quadratische Überstruktur der Anordnung der MFRe.

Wird nun ein Proton aus dem Kohlenstoff-Atom entfernt, dann sieht man auf den Kern eines Bor-Atoms. Es ist unerheblich, welches Proton entfernt wird, immer werden drei Neutronen nahe aneinander rücken und damit werden drei Störstellen entstehen. Analoges gilt für die Atomhülle, da in Bor auch die Anzahl Elektronen gegenüber Kohlenstoff um eins reduziert ist. In der Hülle rücken daher drei Positronen-Strukturen näher zusammen. Damit gibt es im Bor-Atom Neutronen- bzw. Positronen-Strukturen, die schwächer im Kern bzw. in der Atomhülle eingebunden sind womit deren DMFRe größere Radien haben. An diesen größeren und schwächer eingebundenen DMFRen des Bor-Atoms können nun die DMFRe des Magnesiums andocken.

Erst bei der Einlagerung relativ vieler Photonen in das $MgB_2$ (bei 39 K) wird die Nivellierung aller DMFRe des Bors und damit die Nicht-Erfüllung der 2. Bedingung erreicht. In der Standardphysik sind die beiden Merkmale "DMFR" und "Störstelle" in den Atomen unbekannt. Aber mit den beiden Merkmalen gelingt die Interpretation der Supraleitfähigkeit des $MgB_2$ in glänzender Weise.

3. Einfache metallische Elemente

Jedes einzelne Atom und jedes einzelne Elektron kann ein Photon abgeben, weil bei Temperaturen oberhalb des absoluten Nullpunkts immer eine Elektronen- und eine Positronen-Struktur vorhanden sind. Kann aber ein photonenartiges $CP_{nM}$ von einem einzelnen Atom abgegeben werden? Die Antwort ist ein bedingtes NEIN. Warum bedingt? Weil klar gesagt werden muss, um was für ein Atom es sich handelt. Ist es ein sehr kleines Atom oder eines mit magischen Nukleonen-Zahlen, dann trifft das NEIN klar zu. Die Begründung ist: In einem einzelnen solcher Atome sind alle DMFRe der Elektronen einer Atomhülle in einem ultrakurzen Moment gleich, [3], und damit auch die Radien der DMFRe. Also ist die Bedingung für die Schwebung der beiden Primärwellen, die von zwei unterschiedlichen (auch im rechten Winkel zueinander befindlichen) Elektronen der Hülle ausgehen, nicht erfüllt.

Handelt es sich aber um ein metallisches supraleitendes Element wie Quecksilber, Niob oder Bismut aus der 4. bis 6. Periode des Periodensystems, dann ist die Lage etwas komplizierter. Es gibt in diesen Atomhüllen Elektronen von struktureller Ungleichheit.

In den ersten beiden Klassen von Supraleitern wird die Wechselwirkung zwischen zwei benachbarten Atomen besprochen. Die Wechselwirkung verändert dann in beiden benachbarten Atomen die Radien der beteiligten Elektronen. Hat eines der beteiligten Elektronen zusätzlich zum nun veränderten Radius noch einen rechten Winkel zu einer weiteren Elektronen-Achse in seiner Atomhülle, dann sind die beiden Bedingungen erfüllt, so dass das eine Atom nun $CPe_{nM}$ abgeben kann. Es wird z. B. bei Yttrium (Klasse 1) bzw. Bor (Klasse 2) beschrieben, dass einige DMFRe (anteilig) von Störstellen umgeben sind. Die Elektronen-Strukturen sind von struktureller Ungleichheit. Die Attraktion durch die DMFRe benachbarter Atome bewirkt, dass die an Störstellen angrenzenden DMFRe verlängert werden bzw. ihre Radien vergrößert sind und zwar auch in ultrakurzen Momenten.

Auch bei den einfachen metallischen Elementen kommt die Abgabe von $CPe_{nM}$ unterhalb der Sprungtemperatur durch die Wechselwirkung zwischen benachbarten Atomhüllen (wobei je eine Elektronen- und eine Positronen-Struktur miteinander wechselwirken) zustande.

Ergänzend ist aber folgendes zu beachten: Der Absatz [0035] wird damit eingeleitet, dass die große Mehrzahl der supraleitenden Elemente zu den metallischen Übergangselementen der 4. bis 6. Periode des Periodensystems gehört. In allen diesen Elementen überwiegt die Zahl der Neutronen die Zahl der Protonen deutlich. Beginnend bei Titan (4. Periode) sind es je nach Isotop 4 Neutronen mehr, bei Niob (5. Periode) sind es 10 Neutronen und bei Quecksilber (6. Periode) sind es 40 Neutronen mehr. Mit jedem überschüssigen Neutron mehr gibt es im Atomkern und damit auch in der Atomhülle mehr Störstellen. Jede Störstelle vermindert die Einbindung eines benachbarten DMFRes. Also können solche schwächer eingebundenen DMFRe vom Nachbaratom leichter in die Länge gezogen werden, was zur Erfüllung der zwei Bedingungen führt. Wenn man dies mit berücksichtigt, dann wird die Entstehung von $CPe_{nM}$ der einfachen metallischen Übergangselemente (Klasse 3) ganz analog zu der der Klassen 1 und 2 (Absatz [0051]) beschrieben.

Das zusammenfassende und etwas überraschende Verständnis:
Der Mechanismus für die Abgabe von photonenartigen Cooper-Paaren ist bei allen drei Klassen der Supraleiter derselbe.

Die Weiterleitung der photonenartigen $CPe_{nM}$

Die beiden Aspekte der Entstehung und der Weiterleitung von $CPe_{nM}$ sind entkoppelt zu sehen. Hinsichtlich der Weiterleitung ist ein Vergleich mit Photonen bemerkenswert. Ist die Entstehung von Photonen abhängig vom Werkstoff und von der Temperatur? Die Entstehung von Photonen ist deshalb unabhängig vom Werkstoff, weil alle Elemente des Periodensystems Elektronen- und Positronen-Strukturen enthalten. Die Entstehung von Photonen ist auch von der Temperatur unabhängig. Die Temperatur ändert zwar die Qualität der Photonen (Frequenz) und die Häufigkeit der Entstehung, aber ob sich ein einzelnes Photon aus einer Atomhülle löst oder nicht, wird nicht von der Temperatur bestimmt. [Wenn Temperatur durch die thermische Schwingung von z. B. Atomen definiert wird, so befindet man sich mit Schwingungsperioden von $10^{-9}$ bis $10^{-12}$ Sekunden bei Raumtemperatur bzw. noch tieferen Temperaturen auf einer völlig anderen Zeitskala als mit dem Abschießen oder Einfangen eines Photons, das Zeitspannen in der Größenordnung von $10^{-20}$ bis $10^{-18}$ Sekunden umfasst.]

Die analoge Frage für $CPe_{nM}$ lautet: Ist die Entstehung von $CPe_{nM}$ abhängig vom Werkstoff und von der Temperatur? Wie oben in den Absätzen [0035] bis [0053] beschrieben, hängt die Entstehung solcher $CPe_{nM}$ sehr wohl vom jeweiligen Element und damit vom Werkstoff ab. Nur bestimmte Elemente erfüllen die beiden Voraussetzungen für das Abgeben von $CPen_{nM}$. [Z. B. erfüllt abgesehen vom Beryllium keines der Elemente der 1. und 2. Periode die Voraussetzung der rechtwinklig zueinander stehenden Achsen zweier Elektronen-DMFRe. Diese Einsicht kann die Standardphysik nicht haben.] In dieser Hinsicht unterscheiden sich $CPe_{nM}$ von Photonen. Jedoch hängt wie beim Photon auch beim $CP_{nM}$ seine Entstehung nicht von der Temperatur ab.

Wie sieht es bei der Weiterleitung aus? Zwei rhetorische und provokante Fragen lauten:

- Kann ein Photon mit $c_0$ durch das Vakuum fliegen?
- Kann ein photonenartiges CP mit $c_0$ durch das Vakuum fliegen?

Aus der Sicht der Standard-(BCS-)Lehre kann ein massebehaftetes und doppelt geladenes $CP_{BCS}$ nicht durchs Vakuum fliegen und schon gar nicht mit $c_0$.

Aus der Sicht der neuen Modelle kann ein $CP_{nM}$ mit $c_0$ durchs Vakuum und mit $c_{xy}$ durch bestimmte Werkstoffe oder Medien fliegen.

Dass sich ein $CP_{nM}$ durch verschiedene Medien bewegen kann, wird schon in [2] mit der Tabelle auf S. 472 beschrieben. Es liegen aber noch keine experimentellen Daten zu den entsprechenden Geschwindigkeiten $c_{xy}$ vor. $CPe_{nM}$ können sich auch durch verschiedene Keramiken bewegen, zu denen die Cuprate und topologische Isolatoren zu rechnen sind. Auch Halbleiter wie z. B. Silizium sind als Leitungsmedien zu erwähnen.

Weil die Standard-(BCS-)Lehre in den letzten Jahrzehnten nicht die Vorstellung eines photonenartigen $CPs_{nM}$ entwickelt hat, wurden alle Forschungen auf die Werkstoff-Frage konzentriert. Ein durchschlagendes Verständnis unter Berücksichtigung von Ursache und Wirkung wurde nicht erreicht, obwohl eine große Fülle von Aspekten untersucht wurde. Dabei ging es um die kritische Sprungtemperatur, um die Werkstoff-Klassen wie Metall, Kunststoff, Pniktide, Cuprate, um den Kristallaufbau und seine Störungen, um Atomgrößen, um Additive, um Fluss-Schläuche, um magnetische Eindringtiefe usw. usw. Nach meinem Kenntnisstand wurde die elektrische Feldstärke in den verschiedenen Werkstoffen und Medien nicht untersucht.

Dieser Aspekt hat aber eine hohe Bedeutung für die Weiterleitung von Photonenartigen. Dazu muss man wissen, dass sich die elektrische Feldstärke in unterschiedlichen Medien um viele Zehnerpotenzen unterscheidet. Die Skala beginnt bei der elektrischen Feldstärke $\mathfrak{C}$ in einem freien Elektron mit etwa $10^{17}$ V/m und endet bei unseren Umgebungsbedingungen oder im Vakuum bei etwa $10^5$ V/m (Verhältnis etwa $10^{17}/10^5 = 1$ Billion/1). Ein kleiner Ausschnitt aus diesem riesigen Bereich wird schon im Absatz [0042] zu den Elektronegativitäten der Elemente auf der rechten Seite des Periodensystems angesprochen.

In [4] wird auf S. 13 ausgeführt, dass $\mathfrak{C}$ in der Hülle des Wasserstoff-Atoms in der Größenordnung von $10^{15}$ V/m liegt und bei noch größeren Atomradien weiter abnimmt. Wenn also beim Atomradius des Wasserstoff-Atoms von ca. 34 pm $\mathfrak{C} \approx 10^{15}$ V/m ist, dann beträgt $\mathfrak{C}$ im Sauerstoff-Atom mit einem Radius von 73 pm nur noch etwa $4 \cdot 10^{14}$ V/m. Entsprechend gilt für ein voluminöses Barium-Atom mit 215 pm Radius nur noch $\mathfrak{C} \approx 10^{14}$ V/m. In den Zwischenräumen zwischen solchen Atomen, die in der Struktur der Cuprate (z. B. YBCO) vorkommen, dürften nochmals um eine halbe bis eine Zehnerpotenz geringere elektrische Feldstärken (9 herrschen ($3 \cdot 10^{13}$ bis $10^{13}$V/m).

Warum sind die elektrischen Feldstärken so wichtig? Es geht dabei um den Aspekt der geometrischen Größe (d. h. der Amplitude) der elektromagnetischen Wellen der $CPe_{nM}$ und darum, ob sie eine Werkstoff-Struktur passieren können. Ein sehr hohes $\mathfrak{C}$ von $10^{17}$ V/m wie in einem freien Elektron bewirkt, dass ein Photon aus der Umgebung so weit komprimiert wird, dass das Photon seine elektromagnetische Schwingung innerhalb des Radius des freien Elektrons von ca. 1,5 pm fortsetzen kann. Die Komprimierung beträgt also etwa 1 Billion zu 1. Die Komprimierung eines Photons aus der Umgebung in die voluminösen Lagen von YBCO-Werkstoffen beträgt etwa 1 Milliarde bis 100 Millionen zu 1. Entsprechend gilt dies ebenso für $CPe_{nM}$. Das ist bezüglich des in Absatz [0071] angesprochenen Glases bemerkenswert.

In [5] wird berichtet, dass die Käfige aus Kupfer-Oxid in den YBCO- bzw. REBCO-Kristallen, die die Atome aus Seltenen Erden anteilig umschließen, gegeneinander kippen können. Diese Käfige kippen dann, wenn die Atome oder Ionen der Seltenen Erden so groß sind, dass sie als "Kugellager" wirken. Dies wird aus der Sicht der neuen Modelle als ein Jalousie-Effekt gedeutet. Das Kippen der Käfige entspricht dem Kippen einer Lamelle einer Jalousie. Kippen die Käfige aus Kupfer-Oxid zu weit, wird der Spalt für die $CPe_{nM}$ zu klein und sie können nicht mehr passieren. Das Passieren der $CPe_{nM}$ hängt so nicht nur vom Kippen der Cu-O-Käfige, sondern auch von der generellen Feldstärke im Kristall und damit vom Grad der Komprimierung der $CPe_{nM}$ bzw. ihrer aktuellen Amplitude ab.

Der Aspekt der geometrischen Größe wird von zwei weiteren Veröffentlichungen gestützt, [6] und [7].

Wei RUAN und 12 weitere Forscher der Tsinghua Universität in Beijing präsentieren in [6] die Schichtstrukturen von zwei Familien der YBCO-Kristalle: eine Familie, bei der beträchtliche Anteile des Sauerstoffs durch Chlor ersetzt sind, und eine Familie, die die gängigen Kupfer-Oxid-Oktaeder und -Tetraeder aufweist. Innerhalb jeder Familie werden die YBCO-Kristalle in der Weise verändert, dass die zentrale Oktaeder-Schicht aufgelöst und durch zwei räumlich kleinere Tetraeder-Schichten ersetzt wird, wobei zwischen die zwei Tetraeder-Schichten eine Lage aus voluminösen Calcium-Atomen eingeschoben wird. Durch diese Maßnahmen gelingt es den Autoren, in der Chlor-Familie die Sprungtemperatur $T_c$ von 26 K auf 49 K anzuheben. In der Oxid-Familie kann die Sprungtemperatur von 38 K auf 95 K angehoben werden.

Aus der Sicht der neuen Modelle und unter dem Aspekt der geometrischen Größe ist das plausibel. Statt der großen und hinderlichen Oktaeder können die $CPe_{nM}$ nun an den kleineren Tetraedern vorbeifliegen (siehe oben Jalousie-Schlitze). Damit stehen in der Chlor-Familie drei voluminöse Calcium-Lagen zu je 360 pm, also zusammen etwa 1 nm Weite, zur Durchströmung zur Verfügung. In der Oxid-Familie stehen sogar fünf voluminöse Lagen aus Bismut-, Strontium- und Calcium-Atomen zur Durchströmung zur Verfügung. Geht man nach den Atomradien, dann haben diese fünf Lagen zusammen eine Weite von knapp 2000 pm oder 2 nm.

In [7] wird eine neue Technik vorgestellt, mit der man sehr feine Partikel der Größenordnung von Nanometern in besonderen Lösungen gleichmäßig verteilen kann. Die Lösungen werden dann in dünnen Schichten getrocknet und getempert. Auf diese Weise erhält man YBCO-Werkstoffe mit sehr vielen Magnetfluss-Schläuchen, die an den feinverteilten Nanopartikeln haften. Das Interessante ist nun, dass die besten Ergebnisse bezüglich Sprungtemperatur und erreichbarer Supra-Stromdichte mit den feinsten Partikeln aus $BaHfO_3$ und der größten Partikeldichte pro Volumeneinheit erzielt wurden. Die Partikelgröße beträgt nur 7 nm, ist also durchaus vergleichbar mit den 2 nm der o. g. Oxid-Familie.

Bei allen drei Beispielen zum Aspekt der geometrischen Größen kommt es auf das Zusammenspiel von durchströmter Weite in den Werkstoffen und den dort herrschenden elektrischen Feldstärken an, die die Amplituden der $CPe_{nM}$ bestimmen.

Die rhetorische und provokante Frage von Absatz [0055], ob ein $CP_{nM}$ mit $c_0$ durchs Vakuum fliegen kann, muss aus der Sicht der neuen Modelle mit JA beantwortet werden. Um jedoch die Amplitude der $CPe_{nM}$ im Vakuum nicht zu groß werden zu lassen, sollte dieses Vakuum mit einer elektrischen Feldstärke von $10^4$ bis $10^5$ V/m eines Kondensators überlagert werden. Dadurch würde jedoch bewirkt, dass die doppelt negativ geladenen "CPe" (der BCS-Lehre) sofort zum Pluspol des Kondensators fliegen würden. Damit schied diese Versuchsvariante aus.

An dieser Stelle ist der wichtige Unterschied von $CPen_{BCS}$ der Standard-(BCS-)Lehre und von $CPen_{nM}$ der neuen Modelle vorzutragen, um die ab Absatz [0068] vorzuschlagenden Experimente abzusichern.

Problem: Gemäß der BCS-Theorie besteht ein $CP_{BCS}$ aus zwei Elektronen mit gegenteiligem Spin, so dass eine neue bosonische Einheit entsteht. Diese neue Einheit ist die Basis für die Deutung der Supraleitung nach der Standardlehre. Bei metallischen Supraleitern bildet nur ein vergleichsweise kleiner Anteil der Elektronen eines Werkstoffs unterhalb von $T_c$ die $CPe_{BCS}$ aus. Damit sind die beobachteten Stromdichten plausibel zu erklären.

Bei Hochtemperatur-Supraleitern - wie etwa YBCO - wird in der Literatur dagegen häufig betont, dass der Mechanismus der Supraleitung noch nicht verstanden ist. Es kursieren verschiedene Modelle, wie z. B. das des Nobelpreisträgers P. Anderson zum Superaustausch von Elektronen in den Kupferoxidschichten der YBCO-Werkstoffe, [8]. Im Grunde aber sind die nachgewiesenen riesigen Stromdichten von z. B. MA/cm$^2$ [7] nicht verstanden. Mit den photonenartigen $CPen_{nM}$ wird aber unter Einbeziehung der Avogadro-Konstante in Absatz [0063] eine plausible Erklärung vorgetragen.

Lösung: Ein Photon der neuen Modelle entsteht aus den DDMFR-Strukturen eines Elektrons und eines Positrons in einer Atomhülle, [1], Abb. 21.1 c) und hier in den Absätzen [0026] bis [0029]. Somit transportiert ein Photon keine ganzen Elektronen und Positronen sondern nur Elektron- und Positron-Strukturen. Analog entsteht ein photonenartiges $CP_{nM}$ aus der DDMFR-Struktur zweier Elektronen einer passend strukturierten Atomhülle, wie es in den Absätzen [0035] bis [0053] beschrieben wird. Ein solches $CP_{nM}$ transportiert somit keine ganzen Elektronen bzw. Ladungen sondern nur kleine Bruchteile davon. Dies bildet einen starken Kontrast zu den $CPen_{BCS}$. Daher wird in den neuen Modellen für eine bestimmte Stromstärke eine um etliche Zehnerpotenzen größere Anzahl $CPe_{nM}$ benötigt.

Allerdings ist noch unklar, wie viele $CPe_{nM}$ fliegen müssen, um 1 Ampere darzustellen. Da jedes Atom mit der "richtigen" Struktur von Elektronen-DMFRen ein $CP_{nM}$ abgeben kann, ist in einem Stück supraleitenden Materials bei den $CP_{nM}$-Stückzahlen an die Größenordnung der Avogadro-Konstante von $6 \cdot 10^{23}$ pro Mol zu denken.

Nun komprimieren die YBCO-REBCO-Werkstoffe mit ihren werkstoffinternen Feldstärken von etwa $3 \cdot 10^{13}$ bis $10^{13}$ V/m die $CPe_{nM}$ so weit, dass sie die Werkstoffe durchfliegen können (und dabei nicht von Atomgruppen wie Cu-O-Oktaedern blockiert oder von stochastisch verteilten positiven Ladungen - wie immer diese beschaffen sein mögen - angezogen werden). Wenn die elektrischen Feldstärken von $10^{17}$ V/m eines freien Elektrons mit dessen Radius von 1,5 pm korrespondieren, dann korrespondieren die elektrischen Feldstärken von $3 \cdot 10^{13}$ bis $10^{13}$ V/m in den voluminösen Lagen von YBCO / REBCO etwa mit Radien von 5 bis 15 nm. Diese Werte passen gut zu den oben in der Literatur gefundenen Werten von 1 bis 7 nm.

Die $CPe_{nM}$ bzw. die Amplituden ihrer Schwebungen haben die Größenordnung von wenigen Nanometern. So können sie die Lücken zwischen den Hindernissen (Atomgruppen wie z. B. Cu-O-Oktaeder) durchströmen. Die Lücken zwischen den Hindernissen bzw. die in den Kristallschichten durchströmten Weiten ergeben sich aus den Radien bzw. Durchmessern der Atome, die die o. g. relativ niedrigen elektrischen Feldstärken aufweisen. Die Radien der MFRe der die $CPe_{nM}$ erzeugenden Atome und die Radien der Atome mit den relativ niedrigen elektrischen Feldstärken in den Kristallschichten haben etwa die gleiche Größenordnung.

CPe$_{nM}$ können nur bei extrem tiefen Temperaturen von z. B. unter 90 K entstehen. Aber die Weiterleitung der CPe$_{nM}$ kann in einem Material stattfinden, das erstens werkstoffinterne Feldstärken von etwa $3 \cdot 10^{13}$ bis $10^{13}$ V/m aufweist und zweitens bei Raumtemperatur vorliegen kann.

Da CPe$_{nM}$ als Photonenartige betrachtet werden, kommt analog zur Lichtleitung in Glasfasern Glas als Material für die Leitung von CPen$_{nM}$ bei Raumtemperatur infrage, wie z. B. Glas aus diversen Oxiden wie CaO, Al$_2$O$_3$, SiO$_2$, MgO, SrO usw..

Oxydisches Glas ist ein Isolator. Das ist kein Hinderungsgrund für Supraleitung. In [9] wird nachgewiesen, dass die Isolatoren aus Bismut-Antimon, Wismut-Tellurid, Wismut-Selenid, Antimon und Antimon-Tellurid supraleitend sind. Als topologische Isolatoren sind Wismut auf SiC-Einkristallen, binäre Verbindungen von Wismut, Quecksilbertellurid und Cadmiumtellurid bekannt.

Es ist noch einmal darauf hinzuweisen: In der gesamten Supraleitungs-Forschung und -Technik finden die Entstehung und die Weiterleitung der CPe$_{BCS}$ jeweils in ein und demselben Werkstoff statt. Aber die neue Vorstellung eines CPs$_{nM}$ erlaubt es, die im Folgenden beschriebenen Experimente durchzuführen.

Ausführungsformen der Erfindung

Mit der Reihe dieser Experimente werden die Funktionen Entstehung und Weiterleitung der CPe$_{nM}$ Schritt für Schritt getrennt.

Die Figuren 5 bis 9 zeigen verschiedene ringförmige Anordnungen von Leitern aus verschiedenen Materialien, in denen die CPe$_{nM}$ laufen können. Bei allen Experimenten werden die CPe$_{nM}$ per Induktion mit einem Magneten oder per elektrischer Spannung in den beschriebenen drei Klassen von Werkstoffen ausgelöst. Mit den skizzierten Experimenten wird schrittweise das Gebiet des Standardwissens um die Supraleitung verlassen.

Mit der Figur 5 wird der erste entscheidende Schritt auf der Basis der oben entwickelten Vorstellungen gegangen: Figur 5 zeigt einen supraleitenden Ring in einem Kryostaten **17**. In den Ring ist ein Glaskörper **19** eingesetzt. Der Supraleiter **18** bestehend aus Werkstoffen wie z. B. YBCO- oder REBCO-Kristallen mit Schichtstruktur wird unterbrochen und in die Lücke wird ein Glaskörper **19** eingepasst. Die Verbindungstechnik an den Stellen **20** entspricht der der Verbindung moderner lichtleitender Glasfasern. Nach den neuen Modellen fliegen die CPe$_{nM}$ ebenso wie normale Photonen durch den gesamten Glaskörper. Der Vorgang findet bei Temperaturen im kryogenen Bereich statt.

Die Figur 6 zeigt einen supraleitenden Ring in einem Kryostaten **17**. Der Ring besteht aus einem kurzen Supraleiter **18** und langen Glasfasern **19**. In diesem zweiten Schritt werden die Verhältnisse der Versuchsanordnung des ersten Schrittes insofern umgekehrt als der kostbare und schwer herzustellende supraleitende Körper **18** aus z. B. YBCO- oder REBCO-Werkstoffen klein gehalten wird und der Glaskörper **19** die Form langer Glasfasern annimmt. Die Verbindungstechnik an den Stellen **20** entspricht der der Verbindung moderner lichtleitender Glasfasern. [Die Übermittlung von Informationen mit Hilfe von Photonen, die durch Glasfasern geschickt werden, ist heute ein zentraler Bestandteil unserer technischen Kultur.] Mit den Experimenten gemäß der Figur 6 ist zu klären, welche Wellenlängen bzw. Frequenzen die CPe$_{nM}$ haben und ob die benutzten Glasfasersorten für die CPe$_{nM}$ transparent sind. Dabei ist zu berücksichtigen, dass CPe$_{nM}$ mit wenigen Milli-Elektronenvolt besonders energiearm sind und dass ihre Wellenlängen oder Frequenzen weit im Infraroten liegen könnten, s. [1], Kap. 3.3.1 und Kap. 3.3.3. Die Frage scheint aber lösbar zu sein, wenn die verwendeten Gläser in ihrer Zusammensetzung der atomaren Zusammensetzung der YBCO- oder REBCO-Werkstoffe nahekommen und eine innere elektrische Feldstärke von etwa $\mathfrak{E} \approx 3 \cdot 10^{13}$ bis $10^{13}$ V/m haben.

Der dritte Schritt ist von großer technologischer Bedeutung. Seit Beginn der Supraleitungsforschung träumten Forscher und Technologen davon, Supraleiter bei Raumtemperatur betreiben zu können. Figur 7 zeigt einen supraleitenden Ring, der zum Teil in einem Kryostaten **17** und zum Teil außerhalb verläuft. Im kalten Teil des supraleitenden Ringes befindet sich ein supraleitender Werkstoff **18** wie z. B. YBCO oder REBCO in dem sich Atome mit der Eigenschaft befinden, CPe ausbilden zu können. Außerhalb des Kryostaten **17** werden die CPe$_{nM}$ in Glaskörpern bzw. Glasfasern **19** hoher Homogenität weitergeleitet. (Analogie zur Weiterleitung von Photonen in Glasfasern). Die Glasfasern (evtl. auch Kunststofffasern) **19** übertragen die CPe$_{nM}$ bei Raumtemperatur oder einer möglichen großen Spanne von Temperaturen. Die Übertragungslänge wird in erster Linie durch die Dämpfung des "CP-Signals" in den Fasern bestimmt. Dieser Schritt erlaubt es, große Strommengen zu übertragen, weil z. B. in YBCO- oder REBCO-Werkstoffen Mega-Ampere pro Quadratzentimeter nachgewiesen wurden, [7].

Eine Anmerkung zu den in den Absätzen [0070] bis [0072] erwähnten Gläsern: Sollten die Gläser die Elemente Yttrium, Cäsium oder Barium enthalten, dann ist nicht damit zu rechnen, dass von diesen Atomen CPe$_{nM}$ ausgesandt werden. Erster Punkt: Es liegt kein kristalliner Zustand wie in den YBCO- oder REBCO-Kristallen vor und die Zuordnung der supraleitenden Elemente und anderer Atome ist stochastisch. Es fehlt also in der Regel die von einem Nachbaratom ausgehende strukturelle Ungleichheit zweier Elektronen in einem Atom der genannten Elemente. Zweiter Punkt: Wenn die Gläser bzw. Glasfasern gemäß Figur 7 keine tiefen Temperaturen haben, dann befinden sich alle Elektronen eines Atoms immer wieder in ultrakurzen Momenten im selben Zustand, [3]. Gemäß den beiden Punkten fehlt der energetische Unterschied zweier Elektronen in einem Atom, womit die Voraussetzung für die Ausbildung der $CPe_{nM}$ nicht erfüllt ist.

Glasfasern von unterschiedlicher Zusammensetzung dienen demnach rein der Leitung einmal gebildeter und elektrisch geladener photonenartiger $CPe_{nM}$.

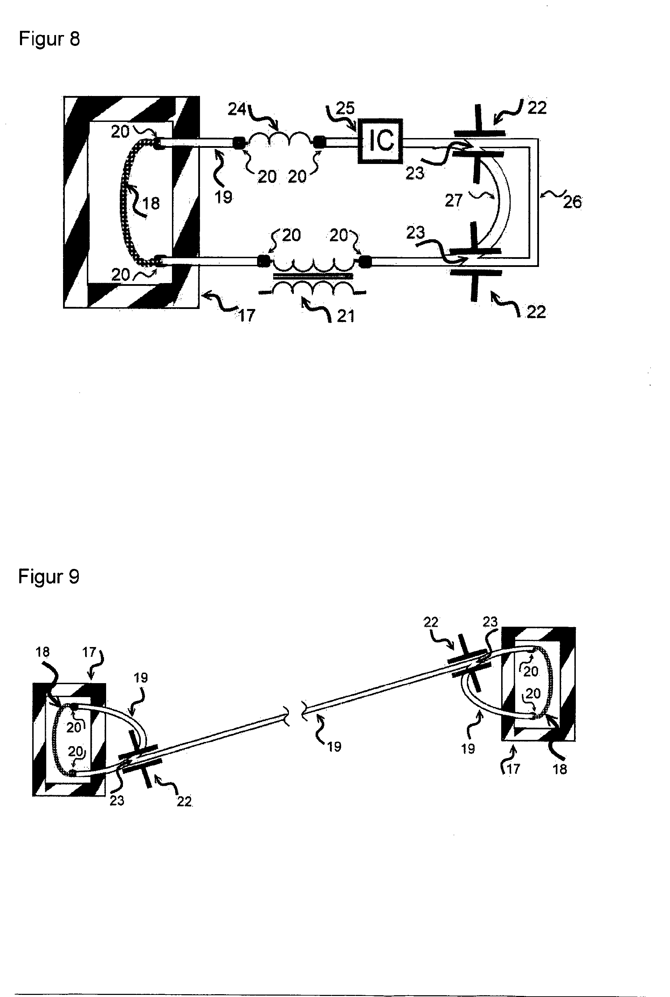

Mit Figur 8 und einem vierten Schritt wird gezeigt, dass in den von einem Supraleiter gespeisten Stromkreis die üblichen Komponenten eingebaut werden können. So kann z. B. die Primärseite eines Transformators **21** oder auch eine Magnetspule **24** von dem in einem Supraleiter induzierten und in einem der verschiedenen Medien weitergeleiteten Strom aus $CPen_{nM}$ durchflossen werden. Eine z. B. aus Glasfasern gewickelte und bei Raumtemperatur zu betreibende Spule ist insbesondere für die Herstellung von Kernspin-Tomographen interessant. Bei diesen Geräten wird aktuell ein enormer Aufwand betrieben, um bei großen lichten Spulendurchmessern von z. B. 700 mm hohe und gleichmäßig verteilte Magnetfeldstärken von 1,5 oder 3,0 Tesla und darüber zu erreichen. Dieser Aufwand ist z. B. gemäß DE 102009017058 oder DE 000010019841 mit dem Einsatz von Niob-Drähten für die Wicklung, mit einer Kühlung durch flüssiges Helium und mit besonderen Schutzvorrichtungen gegen einen möglichen Quench, siehe z. B. DE 0000 696 33 760, verbunden. Quench ist das plötzliche Freisetzen von Wärme im Fall eines plötzlichen Übergangs des Supraleiters vom supraleitenden in den normalleitenden Zustand, wenn seine Sprungtemperatur überschritten werden sollte.

Eine besondere Tragweite zeigt Figur 8 mit dem Einbau von integrierten Chips (IC) **25** in den von einem Supraleiter mit photonenartigen $CPen_{nM}$ gespeisten Stromkreis. Die modernsten Chips weisen Milliarden von Transistoren pro Chip auf engstem Raum auf. Die in einem Chip ablaufenden Schaltprozesse werden von der angelegten Spannung und den durchströmenden Elektronen des elektrischen Stroms ausgelöst. Der Elektronenstrom erhitzt wegen des elektrischen Widerstands der Halbleiter die IC zum Teil bis an die Grenze der thermischen Belastbarkeit.

Mit Figur 8 wird gezeigt, dass der elektrische Strom nicht mehr in der Form der fermionischen Elektronen durch einen IC fließt sondern in der Form der bosonischen photonenartigen $CPe_{nM}$. Wenn aber photonenartige Cooper-Paare durch die Halbleiter strömen, spielt deren elektrischer Widerstand keine Rolle mehr und es kommt nicht zur Erhitzung der Halbleiter. Es könnte ein anderer begrenzender Faktor in den Vordergrund treten: die Transparenz der Halbleiter für die $CPe_{nM}$.

Bei künftigen Entwicklungen der IC ist also eine Anpassung der Frequenz bzw. Wellenlänge der $CPe_{nM}$ an die Transparenz der Halbleiter-Werkstoffe geboten. Einerseits hängt die Transparenz von der Art des Halbleiter-Werkstoffs im IC ab, ob es sich z. B. um Gallium-Arsenid oder Silizium o. ä. handelt. Andererseits ist auch die Frequenz bzw. Wellenlänge der $CPe_{nM}$ nicht beliebig. Sie hängt davon ab, wie der Supraleiter bzw. das CPabgebende Element selbst beschaffen ist und in welchem Verbund (mit einem Nachbaratom) ein Atom dieses Elementes vorliegt. Dieser Verbund bewirkt die strukturelle Ungleichheit zweier Elektronen des $CPe_{nM}$ abgebenden Atoms. Um die $CPe_{nM}$ von einem solchen Atom bzw. Werkstoff auslösen zu können, müssen die Supraleiter-Werkstoffe natürlich bei Temperaturen im kryogenen Bereich vorliegen.

Figur 8 zeigt auch eine Verzweigung **23** des Leiters für die $CPe_{nM}$, also des Glaskörpers bzw. der Glasfasern **19**. Da die $CPe_{nM}$ elektrische Ladung tragen, kann ihr Flugweg direkt durch das elektrische Feld eines Kondensators **22** beeinflusst werden. Durch die Veränderung der Polung und der angelegten Spannung an einem Kondensator **22** kann der Anteil der $CPe_{nM}$ für den einen **26** oder anderen **27** Weg festgelegt werden.

Aus fertigungstechnischen Gründen könnte es vorteilhaft sein, die Verzweigung nicht aus Glas oder Kunststoff bzw. aus Glasfasern oder Kunstfffasern zu fertigen. Alternativ bietet es sich an, die Verzweigung als Rohrverzweigung aus geeignetem Material zu fertigen. Eine solche Rohrgabelung enthält ein Gas, ein Gasgemisch oder ein Vakuum, s. Absatz [0019]. Das ist insofern möglich, weil auch diese drei Medien ebenso wie die genannten Gläser oder Kunststoffe für $CPe_{nM}$ transparent sind.

Die Figur 9 zeigt eine zweckmäßige Kombination von Komponenten der Figur 8 für eine bei Umgebungstemperaturen zu betreibende "Fernleitung" **19** für $CPe_{nM}$, also eine "Stromleitung" - aber nicht der herkömmlichen Art. Es gibt zwei Kryostaten **17** in denen jeweils ein HTSL **18** angeordnet ist. Über die oben eingeführte Verbindungstechnik an den Stellen **20** ist der HTSL z. B. mit einem Glaskörper bzw. mit Glasfasern **19** verbunden. Der HTSL und der Glaskörper bzw. die Glasfasern bilden einen geschlossenen Ring. Wenn also im HTSL per Induktion und bei Temperaturen im kryogenen Bereich die $CPe_{nM}$ in Bewegung gesetzt werden, fließt ein dauerhafter Strom auch im nicht gekühlten Teil des Ringes außerhalb des Kryostaten. Diese Teilsituation gilt für beide Kryostaten, die in Figur 9 links und rechts dargestellt sind. Diese Teilsituation ist direkt vergleichbar mit der in Figur 7 dargestellten.

Neu ist gegenüber Figur 7, dass in die Glaskörper bzw. in die Glasfasern je eine Verzweigung **23** eingefügt ist. Mit Hilfe der elektrischen Felder der beiden Kondensatoren **22** kann die Bahn der $CPe_{nM}$ direkt beeinflusst werden. So ist es möglich, einen Teil der $CPe_{nM}$ aus dem dauerhaften Strom eines Ringes auszukoppeln und auf die lange Distanz der "Fernleitung" **19** zu lenken. Die $CPe_{nM}$ bewegen sich mit Lichtgeschwindigkeit. Also legen sie irdische Distanzen auf der "Fernleitung" in kleinen Bruchteilen einer Sekunde zurück.

Oben wird die provokante Frage gestellt und später bejaht: Kann ein CP mit $c_0$ durchs Vakuum fliegen? Benötigt man kein Glas mehr als Übertragungsmedium, dann entfällt auch dessen innere elektrische o. g. Feldstärke von etwa $\mathfrak{C} \approx$

$3 \cdot 10^{13}$ bis $10^{13}$ V/m. In alternativ verwendeten Gasen oder gar im Vakuum beträgt die elektrische Feldstärke nur etwa $\mathbb{E}$ ≈ $10^5$ V/m, also haben die CPe$_{nM}$ dort eine $10^8$- bis $10^9$-fach größere Ausdehnung als in einem Glas und gleichen damit eher den Photonen (des sichtbaren Spektrums).

Stromtransport mit CPen$_{nM}$ gelingt gemäß der Figuren 5 bis 9 ohne metallische Leiter, aber mit Cupraten, Pniktiden,, Glas(fasern), Kunststoff(fasern), Halbleitern und anderen Werkstoffen oder ganz ohne ein materielles Medium.

In leicht abgewandelten Worten gesagt wurde in der vorstehenden Beschreibung u.a. Folgendes offenbart:

1. Strecke für die Entstehung und Weiterleitung von photonenartigen Cooper-Paaren (CPen), wobei

- die Entstehung der CPe in einem ersten Medium und
- die Weiterleitung in mindestens einem weiteren, verschiedenartigen Medium stattfindet.

2. Strecke nach 1, wobei
das erste Medium ein Supraleiter 18 ist.

3. Strecke nach 1 oder 2, wobei
der Supraleiter solche Elemente des Periodensystems enthält von deren Atomen CPe bei Temperaturen im kryogenen Bereich freigesetzt werden können und dann weitergeleitet werden.

4. Strecke nach 1, 2 oder 3, wobei
das einzelne Element nicht im periodischen System als supraleitend ausgewiesen sein muss.

5. Strecke nach 1, 2, 3 oder 4, wobei
der Supraleiter 18 ein Hoch-Temperatur-Supraleiter ist.

6. Strecke nach 1, 2, 3, 4 oder 5, wobei
der Supraleiter 18 eine Stromdichte von mindestens einem Mega-Ampere pro Quadratzentimeter ermöglicht.

7. Strecke nach 1 oder 2, wobei
das Medium oder die Medien zur Weiterleitung 19 der CPe

- aus der Gruppe der für CPe transparenten polaren oder unpolaren Flüssigkeiten wie z. B. Wasser, Alkohole oder Öle,
- aus der Gruppe der für CPe transparenten Kunststoffe,
- aus der Gruppe der für CPe transparenten Gläser oder
- aus der Gruppe der für CPe transparenten Halbleiter ist.

8. Strecke nach 1, 2, 3, 4, 5, 6 oder 7, wobei
die Gläser in der Form von Glasfasern vorliegen.

9. Strecke nach 8, wobei
die Glasfasern in der Qualität hochtransparenter Lichtleitfasern vorliegen.

10. Strecke nach 1, 2, 3, 4, 5, 6 oder 7, wobei
die Kunststoffe in der Form von Kunststofffasern vorliegen.

11. Strecke nach 7, 8 oder 10, wobei
die sehr hohe Stromdichten von MA/cm$^2$ leitenden Glas- oder Kunststoffasern 19 als Wicklungen für Magnete, Transformatoren, Motoren oder Generatoren eingesetzt werden.

12. Strecke nach1, 2, 3, 4, 5, 6 oder 7, wobei
die für photonenartige Cooper-Paare transparenten Halbleiter zu einem Mikrochip 25 gehören.

13. Strecke nach 12, wobei
elektrische Ladung nicht mehr durch elektrischen Widerstand verursachende Elektronen sondern durch photonenartige Cooper-Paare in einem Halbleiter-Mikrochip 25 transportiert wird.

14. Strecke nach 12, wobei
die Frequenz bzw. Wellenlänge der CPe an die Transparenz der Halbleiter-Werkstoffe der IC 25 angepasst ist.

Versuchsanordnung zum Nachweis des elektrischen Stroms aus photonenartigen Cooper-Paaren (CPen$_{nM}$)

Zweckmäßiger Weise geht man von einer Anordnung gemäß Figur 7 aus. In Absatz [0079] wird das Experiment wie folgt angedeutet: "Der HTSL und der Glaskörper bzw. die Glasfasern bilden einen geschlossenen Ring. Wenn also im HTSL per Induktion und bei Temperaturen im kryogenen Bereich die CPe$_{nM}$ in Bewegung gesetzt werden, fließt ein dauerhafter Strom auch im nicht gekühlten Teil des Ringes außerhalb des Kryostaten." Die genannte Induktion kann auf zwei verschiedene Arten erreicht werden. Entweder es wird eine elektrische Spannung an das HTSL-Leitungs-Medium angelegt und auf diese Weise die CPe$_{nM}$ ausgelöst oder ein Magnetfeld wird mechanisch am HTSL-Leitungs-Medium vorbeigeführt. Bleiben wir bei der letztgenannten Anordnung, weil in [1] mit Abbildung 7 in überaus eindrücklicher Weise das Auslösen eines Supra-Dauerstroms gezeigt wird.

Gemäß Figur 7 wird davon ausgegangen, dass das HTSL-Leitungs-Medium 18 horizontal liegt. Gemäß der Figur 10 wird nun ein magnetischer Nord- oder Südpol 28 vertikal am HTSL-Leitungs-Medium vorbeigeführt. Die Figur 10 ist rein flächig angelegt. Der in die Figur eingetragene Pfeil mit dem verblassenden schmalen Ende soll die vertikale Bewegung des Magneten 28 von unten nach oben (aus der Papierebene heraus) symbolisieren. Die magnetische Induktion löst im HTSL-Leitungs-Medium 18 einen Schauer von CPen$_{nM}$ aus, der mit einem dauerhaften makroskopischen Stromfluss identisch ist. Dieser dauerhafte Strom fließt auch im nicht gekühlten Teil des Ringes 19 außerhalb des Kryostaten, Figur 10. Die Fügung von HTSL-Leitungs-Medium 18 und z. B. Glasfasern 19 gelingt z. B. mit einem transparenten Acrylharzkleber an den Fügestellen 20. Der Nachweis dieses dauerhaften Stroms gelingt mit einem Zangenstrommesser 29, auch Zangenamperemeter genannt. Die Zange umfasst das transparente Leitungs-Medium vollständig. Der Zangenstrommesser 29 stellt das das transparente Leitungs-Medium umgebende Magnetfeld fest und zeigt damit die Höhe des Stromflusses im Leitungs-Medium an. Am 04.02.2025 konnten die Wirkungsweise eines Zangenstrommessers 29 mit digitaler Anzeige und ein zugehöriges Foto aus WIKIPEDIA übernommen werden, Figur 10.

Neben diesem Haupt-Experiment sind weitere Varianten möglich.

A. Ein Magnetpol 28 wird vertikal am horizontal liegenden HTSL-Leitungs-Medium zunächst von oben nach unten und dann von unten nach oben vorbeigeführt. Die Induktion löst zunächst einen Schauer von CPen$_{nM}$ in der einen Richtung des HTSL-Leiters aus und anschließend in der anderen Richtung. Es ergibt sich ein Wechselstrom im HTSL-Leiter und natürlich in einem angrenzenden transparenten Leitungs-Medium.

B. Ein Stabmagnet mit Nord- und Südpol 28 wird mit einer zentralen Bohrung auf eine Rotationsachse geschoben, so dass die Längsachse des Stabmagneten senkrecht zur Rotationsachse orientiert ist. Die Rotationsachse wird parallel zum HTSL-Leiter (innerhalb des Kryostaten) ausgerichtet. Rotiert die Rotationsachse mit dem aufgeschobenen Stabmagneten, so induzieren die abwechselnd am HTSL-Leiter vorbeiziehenden Magnetfelder von Nord- und Südpol Schauer von CPen$_{nM}$ in der einen und dann in der anderen Richtung. Der rotierende Stabmagnet 28 erzeugt ebenfalls einen Wechselstrom im Stromkreis aus HTSL-Leiter und transparentem Leitungs-Medium.

Weitere Varianten von Versuchsanordnungen sind denkbar. Verschiedene Parameter können eingestellt und deren Wirkung beobachtet werden.

Liste der Zitate

[1] W. BUCKEL

Supraleitung
VCH, Weinheim - New York - , 5. Auflage, 1993
ISBN 3-527-29087-7

[2] U. K. W. NEUMANN

Das wunderbare Universum verstehen - Physik 2.0
utzverlag GmbH, München, 2021
ISBN 978-3-658-27839-7

[3] U. K. W. NEUMANN

Warum gibt es das Pauli-Prinzip?
Unveröffentlichter Artikel
Copyright © U. K. W. Neumann, 2021

[4] U. K. W. NEUMANN

Die Hierarchie der elektromagnetischen Strukturen
Unveröffentlichter Artikel
Copyright © U. K. W. Neumann, 2023

[5] P. CAYADO, D. HAUCK, D. BARTHLOTT, M. ERBE, L. HÄNSCH

Determination of the Oxygen Chain Ordering in $REBa_2CuO_7$ by Electrical Conductivity Relaxation Measurements
ACS Applied Electronic Materials, 2021, 3, 5374-5382

[6] W. RUAN, C. HU, J. ZHAO, P. CAI, Y. PENG, C. YE, R. YU, X. Li, Z. HAO, C. JIN, X. ZHOU, Z.-Y. WENG, Y. WANG

Relationship between the parent charge transfer gap and maximum transition temperature in cuprates
Science Bulletin 61, 2016

[7] J. DIEZ-SIERRA, P. LÓPEZ-DOMINGUEZ, H. RIJCKAERT; M. RIKEL, J. HÄNISCH, M. Z. KHAN, M. FALTER, J. BENNEWITZ, H. HUHTINEN, S. SCHÄFER, R. MÜLLER, S. A. SCHUNK, P. PATURI, M. BÄCKER, K. DE BUYSSER, I. VAN DRIESSCHE High Critical Current Density and Enhanced Pinning in Superconducting Films of YBa2Cu3O7-δ Nanocomposites with Embedded BaZrO3, BaHfO3, BaTiO3 and SrZrO3 Nanocrystals ACS Appl. Nano Mater., 2020, 3, 5542 - 5553

[8] Spektrum der Wissenschaft, 2.23, S. 27 bis 29 Abb. 5

[9] D. HSIEH, D. QIAN, L. WRAY, Y. XIA, Y. S. HOR, R. J. CAVA, M. Z. HASAN

A topological Dirac insulator in a 3D quantum spin Hall phase
Nature, Band 452, Nr. 9, 2008, S. 970 bis 974

## Patentansprüche

**1.** Anordnung von aneinander grenzenden Abschnitten verschiedenartiger Leitungs-Medien, **dadurch gekennzeichnet dass**

• in einem ersten Abschnitt ein supraleitendes Medium vorliegt in dem photonenartige Cooper-Paare entstehen und
• in mindestens einem zweiten Abschnitt ein verschiedenartiges Leitungs-Medium vorliegt in dem die photonenartigen Cooper-Paare weitergeleitet werden.

**2.** Anordnung nach Anspruch 1
**dadurch gekennzeichnet, dass**
das supraleitende Medium bzw. der Supraleiter (18) ein oder mehrere Elemente des Periodensystems enthält von dessen bzw. deren Atomen $CPe_{nM}$ bei Temperaturen im kryogenen Bereich freigesetzt werden können und dann weitergeleitet werden.

**3.** Anordnung nach den Ansprüchen 1 und 2
**dadurch gekennzeichnet, dass**
das einzelne Element bzw. das eine oder die mehreren Elemente im periodischen System nicht als supraleitend ausgewiesen ist.

**4.** Anordnung nach den Ansprüchen 1 bis 3
**dadurch gekennzeichnet, dass**

das supraleitende Medium bzw. der Supraleiter (18) ein Hoch-Temperatur-Supraleiter ist.

5.  Anordnung nach den Ansprüchen 1 bis 4
    **dadurch gekennzeichnet, dass**
    das supraleitende Medium bzw. der Supraleiter (18) eine Stromdichte von mindestens einem Mega-Ampere pro Quadratzentimeter ermöglicht.

6.  Anordnung nach Anspruch 1
    **dadurch gekennzeichnet, dass**
    das Leitungs-Medium oder die Leitungs-Medien (19) für die photonenartigen Cooper-Paare

    • aus der Gruppe der für $CPe_{nM}$ transparenten polaren oder unpolaren Flüssigkeiten wie z. B. Wasser, Alkohole oder Öle,
    • aus der Gruppe der für $CPe_{nM}$ transparenten Kunststoffe,
    • aus der Gruppe der für $CPe_{nM}$ transparenten Gläser oder
    • aus der Gruppe der für $CPe_{nM}$ transparenten Halbleiter ist.

7.  Anordnung nach den Ansprüchen 1 und 6
    **dadurch gekennzeichnet, dass**
    die Gläser in der Form von Glasfasern vorliegen.

8.  Anordnung nach Anspruch 7
    **dadurch gekennzeichnet, dass**
    die Glasfasern in der Qualität hochtransparenter Lichtleitfasern vorliegen.

9.  Anordnung nach den Ansprüchen 1 und 6
    **dadurch gekennzeichnet, dass**
    die Kunststoffe in der Form von Kunststofffasern vorliegen.

10. Anordnung nach den Ansprüchen 6, 7 oder 9
    **dadurch gekennzeichnet, dass**
    die sehr hohe Stromdichten von $MA/cm^2$ leitenden Glas- oder Kunststoffasern 19 als Wicklungen für Magnete, Transformatoren, Motoren oder Generatoren eingesetzt werden.

11. Anordnung nach den Ansprüchen 1 und 6
    **dadurch gekennzeichnet, dass**
    die für photonenartige Cooper-Paare ($CPe_{nM}$) transparenten Halbleiter zu einem Mikrochip (25) gehören.

12. Anordnung nach Anspruch 11
    **dadurch gekennzeichnet, dass**
    elektrische Ladung nicht mehr durch elektrischen Widerstand verursachende Elektronen sondern durch photonenartige Cooper-Paare ($CPe_{nM}$) in einem Halbleiter-Mikrochip (25) transportiert wird.

13. Anordnung nach Anspruch 11
    **dadurch gekennzeichnet, dass**
    die Frequenz bzw. Wellenlänge der $CPe_{nM}$ an die Transparenz der Halbleiter-Werkstoffe der IC (25) angepasst ist.

Figur 1a

Figur 1b

Figur 2a

Figur 2b

Figur 3

Figur 4a

Figur 4b

Figur 5

Figur 6

Figur 7

Figur 8

Figur 9

Figur 10

Europäisches
Patentamt

European
Patent Office

Office européen
des brevets

# EUROPÄISCHER RECHERCHENBERICHT

**Nummer der Anmeldung**

EP 25 00 0018

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2024/045009 A1 (KODAMA MOTOMUNE [JP] ET AL) 8. Februar 2024 (2024-02-08) * Absatz [0037] - Absatz [0074]; Abbildungen 1A-2D * | 1-13 | INV. H10N60/00 |
| X | CHRIS W BUMBY ET AL: "Development of a brushless HTS exciter for a 10 kW HTS synchronous generator", SUPERCONDUCTOR SCIENCE AND TECHNOLOGY, IOP PUBLISHING, TECHNO HOUSE, BRISTOL, GB, Bd. 29, Nr. 2, 12. Januar 2016 (2016-01-12), Seite 24008, XP020297274, ISSN: 0953-2048, DOI: 10.1088/0953-2048/29/2/024008 [gefunden am 2016-01-12] * Seite 2 - Seite 4; Abbildungen 1-5 * | 1-13 | |

----- | | | |

**RECHERCHIERTE SACHGEBIETE (IPC)**

H10N

Der vorliegende Recherchenbericht wurde für alle Patentansprüche erstellt

| Recherchenort | Abschlußdatum der Recherche | Prüfer |
|---|---|---|
| München | 4. Juli 2025 | Gröger, Andreas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..............................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 00 0018

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-07-2025

| Im Recherchenbericht angeführtes Patentdokument | Datum der Veröffentlichung | Mitglied(er) der Patentfamilie | Datum der Veröffentlichung |
|---|---|---|---|
| US 2024045009 A1 | 08-02-2024 | JP 7405783 B2 | 26-12-2023 |
| | | JP 2022118461 A | 15-08-2022 |
| | | US 2024045009 A1 | 08-02-2024 |
| | | WO 2022168483 A1 | 11-08-2022 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3281211 B1
- DE 102009017058
- DE 000010019841
- DE 000069633760

**In der Beschreibung aufgeführte Nicht-Patentliteratur**

- **W. BUCKEL**. Supraleitung. VCH, 1993
- **U. K. W. NEUMANN**. Das wunderbare Universum verstehen - Physik 2.0. utzverlag GmbH, 2021
- **U. K. W. NEUMANN**. *Warum gibt es das Pauli-Prinzip?*, 2021
- **U. K. W. NEUMANN**. *Die Hierarchie der elektromagnetischen Strukturen*, 2023
- **P. CAYADO, D. HAUCK, D. BARTHLOTT, M. ERBE, L. HÄNSCH**. Determination of the Oxygen Chain Ordering in REBa2CuO7 by Electrical Conductivity Relaxation Measurements. *ACS Applied Electronic Materials*, 2021, vol. 3, 5374-5382
- **W. RUAN, C. HU, J. ZHAO, P. CAI, Y. PENG, C. YE, R. YU, X. LI, Z. HAO, C. JIN, X. ZHOU, Z.-Y. WENG, Y. WANG**. Relationship between the parent charge transfer gap and maximum transition temperature in cuprates. *Science Bulletin*, 2016, vol. 61
- **J. DIEZ-SIERRA** ; **P. LÓPEZ-DOMINGUEZ** ; **H. RIJCKAERT** ; **M. RIKEL** ; **J. HÄNISCH** ; **M. Z. KHAN** ; **M. FALTER** ; **J. BENNEWITZ** ; **H. HUHTINEN** ; **S. SCHÄFER**. High Critical Current Density and Enhanced Pinning in Superconducting Films of YBa2-Cu3O7-$\delta$ Nanocomposites with Embedded BaZrO3, BaHfO3, BaTiO3 and SrZrO3 Nanocrystals. *ACS Appl. Nano Mater.*, 2020, vol. 3, 5542-5553
- **D. HSIEH, D. QIAN, L. WRAY, Y. XIA, Y. S. HOR, R. J. CAVA, M. Z. HASAN**. A topological Dirac insulator in a 3D quantum spin Hall phase. *Nature*, 2008, vol. 452 (9), 970-974